# EUROPÄISCHE PATENTANMELDUNG

(11) **EP 4 152 395 A1**
(43) Veröffentlichungstag der Anmeldung: **22.03.2023**
(21) Anmeldenummer: 21197603.0
(22) Anmeldetag: 20.09.2021
(51) Int. Cl.: H01L 27/11556, H01L 21/3065, H01L 27/11582

(54) **VERFAHREN ZUM HERSTELLEN EINES DREIDIMENSIONAL-INTEGRIERTEN HALBLEITERSPEICHERS**

(71) Anmelder: Fraunhofer-Gesellschaft zur Förderung der angewandten Forschung e.V., 80686 München (DE)
(72) Erfinder: HEIGL, Martin, 80686 München (DE); BUI-TRAN, Thi Xuan Anh, 80686 München (DE); MERKEL, Karl-Reinhard, 80686 München (DE)
(74) Vertreter: Hersina, Günter

(57) **Zusammenfassung**

Das hierin beschriebene Konzept betrifft ein Verfahren zum Herstellen eines dreidimensional-integrierten Halbleiterspeichers (1000). Hierfür wird zunächst ein Schichtstapel (100) mit mehreren Einzelschichten (101, 102) unterschiedlicher Materialtypen bereitgestellt. Zunächst werden Einzelschichten (101) eines ersten Materialtyps selektiv aus dem Schichtstapel (100) herausgeätzt. Hierfür wird erfindungsgemäß ein Trockenätzprozess eingesetzt. Anschließend werden Einzelschichten (103) eines dritten Materialtyps erzeugt, indem entweder Leerräume (107) mit einem dritten Material befüllt werden, oder die Einzelschichten (102) des zweiten Materialtyps in die Einzelschichten (103) des dritten Materialtyps gewandelt werden, oder die Einzelschichten (102) des zweiten Materialtyps mit einem Material des dritten Materialtyps belegt werden. Leerräume (108) zwischen den Einzelschichten (103) des dritten Materialtyps können dann nochmals mit einem vierten Material gefüllt werden, sodass in diesen Leerräumen (108) Einzelschichten (104) eines vierten Materialtyps entstehen. Mittels eines geeigneten vertikalen Ätzprozesses, können die Einzelschichten (104) des vierten Materialtyps voneinander elektrisch getrennt werden, um so eine Word Line des erzeugten dreidimensional-integrierten Halbleiterspeichers (1000) zu bilden.

## Beschreibung

Das hierin beschriebene innovative Konzept betrifft das technische Gebiet der Herstellung von dreidimensional integrierten Halbleiterspeichern, wie z.B. dreidimensionalen NAND Flash Speichern. Bei der dreidimensionalen Integration werden, im Vergleich zur herkömmlichen Planartechnik (x-y-Richtung), Bauelemente zusätzlich in vertikaler Richtung (z-Richtung) erstellt. Das hierin beschriebene innovative Konzept schafft neuartige Verfahren zum Herstellen derartiger dreidimensional integrierter Halbleiterspeicher unter Verwendung von Trockenätzprozessen.

Sogenannte Flash-Speicherelemente werden beispielsweise mit NAND-Zellen realisiert. Um eine hohe Speicherkapazität von Flash-Speichern zu erzielen, werden die dafür benötigten NAND-Zellen vertikal übereinander angeordnet, was auch als dreidimensionale Systemintegration bezeichnet wird. Ein derartiger dreidimensionaler Speicherbaustein mit mehreren vertikal übereinander angeordneten Speicherzellen wird auch als 3D NAND bezeichnet.

In bisherigen Herstellungsverfahren zum Herstellen von 3D NAND Speichern werden viele einzelne Schichten von Si₃N₄-SiO₂ (Siliziumnitrid - Silizium(di-)oxid) aufeinander gestapelt, sodass ein vertikaler Schichtstapel entsteht. Mittels vertikal geätzter Löcher innerhalb des Schichtstapels werden die einzelnen Schichten des Schichtstapels dann lateral freigelegt. Anschließend werden die Si₃N₄-Schichten selektiv zu SiO₂ geätzt. Die dadurch entstehenden Leerräume in Form von freien, d.h. unausgefüllten, Spalten werden dann mit Wolfram gefüllt, welches später die Word-Line des Speichers bildet.

Das selektive Ätzen von Si₃N₄ selektiv zu SiO₂ wird bisher mittels nasschemischen Verfahren unter Verwendung von heißer Phosphorsäure (bei etwa 160°C) durchgeführt, die in das vertikale Loch im Schichtstapel fließt und dort die innerhalb des Lochs freigelegten und zugänglich gemachten einzelnen Schichten erreicht, um diese in lateraler Richtung aus dem Schichtstapel heraus zu ätzen.

Um die Speicherkapazität des vertikalen Schichtstapels bzw. des 3D NAND Speichers zu erhöhen, muss die Anzahl der übereinander gestapelten Einzelschichten erhöht werden.

Dadurch müssen aber natürlich auch die vertikalen Löcher immer tiefer ausgeführt werden, d.h. das Aspektverhältnis (Tiefe zu Breite) der vertikalen Löcher muss erhöht werden. Durch die Erhöhung des Aspektverhältnisses dieser Löcher (aktuell z.B. 50:1) wird es allerdings zunehmend schwieriger, mit der nasschemischen Ätzlösung eine homogene Ätzrate von Si₃N₄ selektiv zu SiO₂ entlang des vertikalen Lochs zu erzielen. Das heißt, mit fortschreitender Tiefe des Lochs werden die am unteren Ende des Lochs gelegenen Schichten, bei gleicher Ätzdauer, deutlich weniger weggeätzt als die oben am Locheingang liegenden Schichten.

Das daraus resultierende Problem ist eine Limitierung in der Anzahl der Einzelschichten innerhalb des Schichtstapels und der damit verbundenen Limitierung der Speicherkapazität. Das heißt, die vertikalen Löcher können nicht beliebig tief ausgeführt werden, da es ansonsten zu immer deutlicher ausgeprägten inhomogenen Ätzraten kommt. Heutzutage können etwa bis zu 96 Einzelschichten mit dieser Technik lateral weggeätzt werden. Somit ist die Anzahl von Einzelschichten innerhalb eines Schichtstapels auf ebendiese etwa 96 Einzelschichten begrenzt. Dies bedeutet jedoch auch, dass der Schichtstapel nicht wesentlich mehr Einzelschichten aufweisen darf, was jedoch die Speicherkapazität des Schichtstapels dementsprechend begrenzt.

Daher wäre es wünschenswert, bisherige Verfahren zum Herstellen von 3D Halbleiterspeichern dahingehend zu verbessern, dass die Ätzratenhomogenität beim selektiven lateralen Entfernen von Einzelschichten gesteigert wird, wodurch die Anzahl der Einzelschichten innerhalb eines Schichtstapels erhöht werden kann, um die Speicherkapazität des Halbleiterspeichers dementsprechend zu vergrößern.

Dieses Ziel wird erreicht mit einem Verfahren gemäß Anspruch 1 sowie mit einem alternativen Verfahren gemäß Anspruch 6. Weitere Ausführungsformen und vorteilhafte Aspekte der jeweiligen Verfahren sind in den jeweils abhängigen Patentansprüchen genannt.

Beide erfindungsgemäßen Verfahren dienen zum Herstellen eines solchen verbesserten dreidimensional-integrierten Halbleiterspeichers. Das erfindungsgemäße Verfahren gemäß einem ersten Ausführungsbeispiel mit den Merkmalen aus Anspruch 6 beinhaltet, unter anderem, das Bereitstellen eines Substrats. Auf dem Substrat wird ein Schichtstapel mit mehreren Einzelschichten erzeugt, indem abwechselnd mehrere Einzelschichten eines ersten Materialtyps (z.B. ein Verbindungshalbleiter, wie beispielsweise SiGe) sowie mehrere Einzelschichten eines unterschiedlichen zweiten Materialtyps (z.B. ein Elementhalbleiter, wie zum Beispiel Si) aufgetragen werden. Die jeweiligen Einzelschichten werden abwechselnd vertikal übereinander gestapelt, sodass ein, sich vom Substrat aus vertikal nach oben erstreckender, Schichtstapel entsteht. In diesem Schichtstapel wird mindestens eine erste vertikale Ausnehmung strukturiert. Diese erste vertikale Ausnehmung erstreckt sich von oben nach unten, d.h. von einer dem Substrat abgewandten Seite des Schichtstapels ausgehend vertikal nach unten in Richtung des Substrats. Die erste vertikale Ausnehmung erstreckt sich hierbei durch zumindest eine der Einzelschichten, vorzugsweise durch mehrere Einzelschichten, und weiter bevorzugt durch alle Einzelschichten des Schichtstapels hindurch bis hinunter zum Substrat. Innerhalb dieser ersten vertikalen Ausnehmung wird eine Stützstruktur erzeugt. Diese Stützstruktur ist mit den jeweiligen Einzelschichten verbunden, um diese während den weiteren Prozessschritten mechanisch zu stabilisieren bzw. zu stützen. Das Verfahren beinhaltet ferner einen Schritt des Strukturierens von mindestens einer zweiten vertikalen Ausnehmung in dem Schichtstapel. Diese zweite vertikale Ausnehmung erstreckt sich ebenfalls von oben nach unten, d.h. von einer dem Substrat abgewandten Seite des Schichtstapels ausgehend vertikal nach unten in Richtung des Substrats. Die zweite vertikale Ausnehmung erstreckt sich außerdem durch zumindest eine der Einzelschichten, vorzugsweise durch mehrere Einzelschichten, und weiter bevorzugt durch alle Einzelschichten des Schichtstapels hindurch bis hinunter zum Substrat. Die zweite vertikale Ausnehmung bildet einen Zugang zu den jeweiligen Einzelschichten des Schichtstapels, in diesem Fall zu den im Schichtstapel zu diesem Zeitpunkt vorhandenen Einzelschichten des ersten und zweiten Materialtyps. Das heißt, mittels der zweiten vertikalen Ausnehmung werden die jeweiligen Einzelschichten des ersten und zweiten Materialtyps innerhalb und entlang der zweiten vertikalen Ausnehmung freigelegt und lateral zugänglich gemacht. Beispielsweise kann ein Ätzgas durch die zweite vertikale Ausnehmung in den Schichtstapel einströmen und darin die jeweils zugänglich gemachten Einzelschichten des ersten und zweiten Materialtyps erreichen. Das Verfahren beinhaltet einen Schritt des selektiven Entfernens der zugänglich gemachten Einzelschichten des ersten Materialtyps unter Anwendung eines in lateraler Richtung gerichteten Ätzprozesses mittels eines Ätzmediums, z.B. mittels eines Ätzgases. Das Ätzgas gelangt durch die zweite vertikale Ausnehmung hindurch in den Schichtstapel hinein, wo es die darin abschnittsweise freigelegten Einzelschichten des ersten und zweiten Materialtyps erreicht. Das Ätzgas entfernt die Einzelschichten des ersten Materialtyps selektiv zu den Einzelschichten des zweiten Materialtyps, und zwar in einer lateralen Richtung. Unter einer lateralen Richtung ist eine Richtung zu verstehen, die im Wesentlichen orthogonal zur (vertikalen) Schichtrichtung des Schichtstapels verläuft. Das Ätzgas entfernt also die Einzelschichten des ersten Materialtyps in lateraler Richtung, und zwar von der ersten vertikalen Öffnung ausgehend lateral (z.B. horizontal) nach außen. Das heißt, die Einzelschichten des ersten Materialtyps werden selektiv zu den Einzelschichten des zweiten Materialtyps aus dem Schichtstapel herausgeätzt. Nach diesem selektiven Entfernen der Einzelschichten des ersten Materialtyps verbleiben lediglich die Einzelschichten des zweiten Materialtyps in dem Schichtstapel. Diese verbleibenden Einzelschichten des zweiten Materialtyps stützen sich dabei weiterhin an der Stützstruktur ab. Zwischen den verbleibenden Einzelschichten des zweiten Materialtyps bilden sich dementsprechend, an den Stellen wo zuvor die mittlerweile entfernten Einzelschichten des ersten Materialtyps waren, Leerräume. Das erfindungsgemäße Verfahren gemäß diesem ersten Ausführungsbeispiel beinhaltet ferner das Erzeugen von Einzelschichten eines dritten Materialtyps, indem in die entstandenen Leerräume ein drittes Material eingebracht wird, sodass sich innerhalb dieser Leerräume zwischen den verbleibenden Einzelschichten des zweiten Materialtyps jeweils Einzelschichten eines dritten Materialtyps ausbilden. Der dritte Materialtyp ist unterschiedlich zu dem zweiten Materialtyp. Das Verfahren beinhaltet des Weiteren einen Schritt des Strukturierens von mindestens einer dritten vertikalen Ausnehmung in dem Schichtstapel. Diese dritte vertikale Ausnehmung erstreckt sich ebenfalls von oben nach unten, d.h. von einer dem Substrat abgewandten Seite des Schichtstapels ausgehend vertikal nach unten in Richtung des Substrats. Die dritte vertikale Ausnehmung erstreckt sich außerdem durch zumindest eine der Einzelschichten, vorzugsweise durch mehrere Einzelschichten, und weiter bevorzugt durch alle Einzelschichten des Schichtstapels hindurch bis hinunter zum Substrat. Die dritte vertikale Ausnehmung bildet einen Zugang zu den jeweiligen Einzelschichten des Schichtstapels, in diesem Fall zu den im Schichtstapel zu diesem Zeitpunkt vorhandenen Einzelschichten des zweiten und dritten Materialtyps. Das Verfahren beinhaltet ein selektives Entfernen der zugänglich gemachten Einzelschichten des zweiten Materialtyps selektiv zu den Einzelschichten des dritten Materialtyps. Dieses selektive Entfernen geschieht unter Anwendung eines in lateraler Richtung gerichteten Ätzprozesses mittels eines Ätzmediums. Das Ätzmedium kann ein Ätzgas (auch ein ionisiertes Ätzgas bzw. Plasma wie bei einer Plasmaätzung) oder eine nasschemische Ätzlösung sein. Das Ätzmedium gelangt durch die dritte vertikale Ausnehmung hindurch in den Schichtstapel und zu den, innerhalb der dritten vertikalen Ausnehmung zugänglich gemachten, Einzelschichten des zweiten und dritten Materialtyps. Das Ätzmedium entfernt die Einzelschichten des zweiten Materialtyps in lateraler Richtung selektiv zu den Einzelschichten des dritten Materialtyps, sodass nach dem selektiven Entfernen des zweiten Materialtyps die Einzelschichten des dritten Materialtyps verbleiben. Zwischen den verbleibenden Einzelschichten des dritten Materialtyps bilden sich somit, an den Stellen wo zuvor die mittlerweile entfernten Einzelschichten des zweiten Materialtyps waren, Leerräume. Das erfindungsgemäße Verfahren zeichnet sich unter anderem dadurch aus, dass die Einzelschichten des ersten Materialtyps Siliziumgermanium aufweisen oder aus Siliziumgermanium bestehen. Außerdem wird der in lateraler Richtung verlaufende Ätzprozess zum selektiven Entfernen der Einzelschichten des ersten Materialtyps in Form eines Trockenätzprozesses unter Verwendung eines Ätzgases ausgeführt. Durch die Verwendung eines derartigen Schichtstapels können Trockenätzprozesse zur lateralen Spalterzeugung (Leerräume) verwendet werden, die im Vergleich zu den bisherigen nasschemischen Ätzverfahren keine Benetzungsprobleme aufweisen und auch bezüglich des Diffusionstransports deutlich besser optimiert werden können. Der Trockenätzprozess weist im Vergleich zu den nasschemischen Verfahren deutlich mehr Freiheitsgrade bei der Prozessoptimierung auf, wie zum Beispiel ein größeres Temperaturfenster, einen variablen Prozessdruck, oder aber auch verschiedene Prozessgasflüsse. Mit diesen Möglichkeiten können die selektiven Ätzungen hinsichtlich der Ätzratenhomogenität entlang eines vertikalen Lochs im Speicherstapel trotz immer weiter steigenden Aspektverhältnissen optimiert werden.

Das erfindungsgemäße Verfahren gemäß einem zweiten Ausführungsbeispiel, mit den Merkmalen von Anspruch 1, stellt eine Alternative zu dem ersten Ausführungsbeispiel (Anspruch 6) bereit. Beide Verfahren dienen letztendlich jedoch dazu, einen dreidimensional integrierten Halbleiterspeicher herzustellen. Das heißt, beide erfindungsgemäße Verfahren lösen dieselbe objektive technische Aufgabe, jedoch mit alternativen Verfahrensschritten. Beispielsweise unterscheidet sich das Verfahren gemäß der alternativen zweiten Ausführungsform (Anspruch 1) von der zuvor diskutierten Ausführungsform (Anspruch 6) unter anderem in der Art der Erzeugung der Einzelschichten des dritten Materialtyps. Gemäß der alternativen zweiten Ausführungsform (Anspruch 1) werden nämlich die Einzelschichten des dritten Materialtyps unter Beibehaltung der zwischen den Einzelschichten des zweiten Materialtyps bestehenden Leerräume erzeugt, sodass sich die erzeugten Einzelschichten des dritten Materialtyps nun an denjenigen Stellen im Schichtstapel befinden, an denen sich zuvor die Einzelschichten des zweiten Materialtyps befanden. Dadurch spart man sich mehrere in der ersten Ausführungsform (Anspruch 6) beschriebene Prozessschritte, wie beispielsweise das Füllen der Leerräume mit dem dritten Material, um dadurch die Einzelschichten des dritten Materialtyps zu erzeugen, sowie das anschließende Entfernen der Einzelschichten des zweiten Materialtyps.

Gemäß dieser alternativen zweiten Ausführungsform (Anspruch 1) können die Einzelschichten des dritten Materialtyps beispielsweise durch eine, zumindest teilweise, (thermische) Oxidation der Einzelschichten des zweiten Materialtyps erzeugt werden. Das heißt, die Einzelschichten des zweiten Materialtyps (z.B. Elementhalbleiter Si) können sich durch thermische Oxidation, also durch Reaktion mit Sauerstoff, zu einem Oxid umwandeln, wodurch sich die Eigenschaften, d.h. der Materialtyp, dieser Einzelschichten ändert. Beispielsweise könnten die Einzelschichten des zweiten Materialtyps zunächst einen elektrisch halbleitenden Materialtyp (z.B. Elementhalbleiter Si) aufweisen. Durch das Umwandeln in ein Oxid könnten diese Einzelschichten dann elektrisch isolierend werden, d.h. der Materialtyp verändert sich von ursprünglich elektrisch halbleitend zu elektrisch isolierend (z.B. Isolator SiO₂). Das heißt, die Einzelschichten des dritten Materialtyps (z.B. Isolator SiO₂) könnten mittels thermischer Oxidation aus den Einzelschichten des zweiten Materialtyps (z.B. Halbleiter Si) erzeugt werden. Denkbar wäre auch, dass die Einzelschichten des zweiten Materialtyps (z.B. Elementhalbleiter Si) alternativ oder zusätzlich mit einem Beschichtungsmaterial belegt werden, beispielsweise unter Anwendung eines Beschichtungsverfahrens. Das Beschichtungsmaterial kann beispielsweise elektrisch isolierende Eigenschaften aufweisen, und beispielsweise ein Oxid oder Nitrid aufweisen oder aus einem Oxid oder Nitrid bestehen. Somit würden also die Einzelschichten des dritten Materialtyps dadurch erzeugt, dass die Einzelschichten des zweiten Materialtyps mit einem Beschichtungsmaterial belegt werden. Das Beschichtungsmaterial kann hierbei andere Eigenschaften, d.h. einen anderen Materialtyp, aufweisen als die Einzelschichten des zweiten Materialtyps.

Einige Ausführungsbeispiele sind exemplarisch in der Zeichnung dargestellt und werden nachstehend erläutert. Es zeigen:
- Figs. 1A-1E: schematische seitliche Schnittansichten zur Versinnbildlichung einzelner Verfahrensschritte zum Herstellen eines konventionellen 3D Halbleiterspeichers mit herkömmlichen Verfahren gemäß dem Stand der Technik,
- Fig. 1F: einen Ausschnitt einer schematischen seitlichen Schnittansicht einer vertikalen Ausnehmung in einem herkömmlichen Schichtstapel gemäß dem Stand der Technik zur Verdeutlichung der mit den bisher eingesetzten Methoden bestehenden Problematiken,
- Figs. 2A-2K: schematische seitliche Schnittansichten zur Versinnbildlichung einzelner Verfahrensschritte zum Herstellen eines erfindungsgemäßen 3D Halbleiterspeichers mittels einem Verfahren gemäß einer ersten Ausführungsform der vorliegenden Erfindung, und
- Figs. 3A-3D: schematische seitliche Schnittansichten zur Versinnbildlichung einzelner Verfahrensschritte zum Herstellen eines erfindungsgemäßen 3D Halbleiterspeichers mittels einem Verfahren gemäß einer zweiten alternativen Ausführungsform der vorliegenden Erfindung.

Im Folgenden werden Ausführungsbeispiele mit Bezug auf die Figuren näher beschrieben, wobei Elemente mit derselben oder ähnlichen Funktion mit denselben Bezugszeichen versehen sind.

Verfahrensschritte, die im Rahmen der vorliegenden Offenbarung abgebildet bzw. beschrieben sind, können auch in einer anderen als der abgebildeten beziehungsweise beschriebenen Reihenfolge ausgeführt werden. Außerdem sind Verfahrensschritte, die ein bestimmtes Merkmal einer Vorrichtung betreffen mit ebendiesem Merkmal der Vorrichtung austauschbar, was ebenso anders herum gilt.

Sofern innerhalb dieser Offenbarung von einer vertikalen Richtung die Rede ist, so ist darunter diejenige Richtung zu verstehen, die senkrecht auf der von einer Einzelschicht aufgespannten Ebene steht. Wenn sich also beispielsweise eine Einzelschicht bezüglich ihrer Länge und Breite in der x-y-Ebene erstreckt, so entspräche die vertikale Richtung der z-Achse. In diesem Fall würde sich beispielsweise auch die Dicke der Einzelschicht in z-Richtung bemessen. Innerhalb des Schichtstapels sind die jeweiligen Einzelschichten in ebendieser vertikalen Richtung (z-Achse) übereinander gestapelt, sodass sich der Schichtstapel, vom Substrat ausgehend, vertikal nach oben erstreckt.

Sofern innerhalb dieser Offenbarung von einer lateralen Richtung die Rede ist, so ist darunter diejenige Richtung zu verstehen, die innerhalb bzw. parallel zu der von einer Einzelschicht aufgespannten (x-y-) Ebene verläuft bzw. senkrecht zur vertikalen Erstreckungsrichtung (z-Achse) des Schichtstapels verläuft. Im Falle eines sich vertikal erstreckenden Schichtstapels kann die laterale Richtung also im Wesentlichen gleichbedeutend mit einer horizontalen Richtung sein.

Sofern innerhalb dieser Offenbarung von Einzelschichten unterschiedlicher Materialtypen die Rede ist, so ist darunter zunächst einmal zu verstehen, dass die unterschiedlichen Materialtypen unterschiedliche physikalische und/oder chemische und/oder elektrische Eigenschaften aufweisen. Beispielsweise kann unterschieden werden zwischen elektrisch isolierenden Materialtypen und elektrisch leitfähigen Materialtypen. Unter den elektrisch leitfähigen Materialtypen kann weiter unterschieden werden in Leiter und Halbleiter. Die Halbleiter können dann wiederum weiter unterschieden werden in Elementhalbleiter, wie z.B. (dotiertes) Silizium, und in Verbindungshalbleiter, wie z.B. II-VI, III-III oder IV-IV (z.B. SiGe) Halbleiter. Unterschiedliche Materialtypen können beispielsweise auch ein unterschiedliches Ätzverhalten aufweisen. Beispielsweise können zwei unterschiedliche Materialtypen eine hohe Ätzselektivität relativ zueinander aufweisen. So kann beispielsweise ein erster Materialtyp sehr gut mit einem bestimmten Ätzmedium reagieren, während hingegen ein zweiter Materialtyp kaum bis gar nicht mit demselben Ätzmedium reagiert, sodass der erste Materialtyp mittels des Ätzmediums strukturiert wird während hingegen der zweite Materialtyp nahezu unverändert bleibt. Einzelschichten unterschiedlicher Materialtypen können unterschiedliche Materialien bzw. Materialkombinationen aufweisen oder aus unterschiedlichen Materialien bzw. Materialkombinationen bestehen.

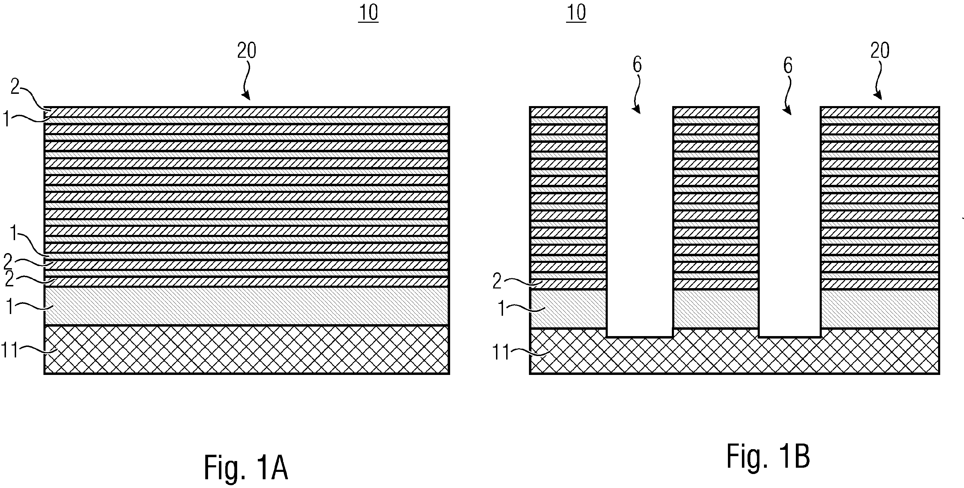

Bevor das erfindungsgemäße Verfahren beschrieben wird, soll zunächst kurz der Stand der Technik diskutiert werden. Die Figuren 1A bis 1E zeigen ein Verfahren zum Herstellen eines dreidimensional-integrierten Halbleiterspeichers 10 gemäß dem Stand der Technik.

Wie in Figur 1A zu sehen ist, werden zunächst auf einem Siliziumsubstrat 11 mehrere Einzelschichten 1, 2 abwechselnd übereinander angeordnet. Dabei handelt es sich um Einzelschichten 1 aus Siliziumoxid (SiO₂) sowie um Einzelschichten 2 aus Siliziumnitrid (Si₃N₄). Diese abwechselnd übereinander angeordneten Einzelschichten 1, 2 bilden einen vertikalen Schichtstapel 20.

Figur 1B zeigt einen nächsten Prozessschritt, wobei ein oder mehrere vertikale Ausnehmungen 6 in den vertikalen Schichtstapel 20 strukturiert werden.

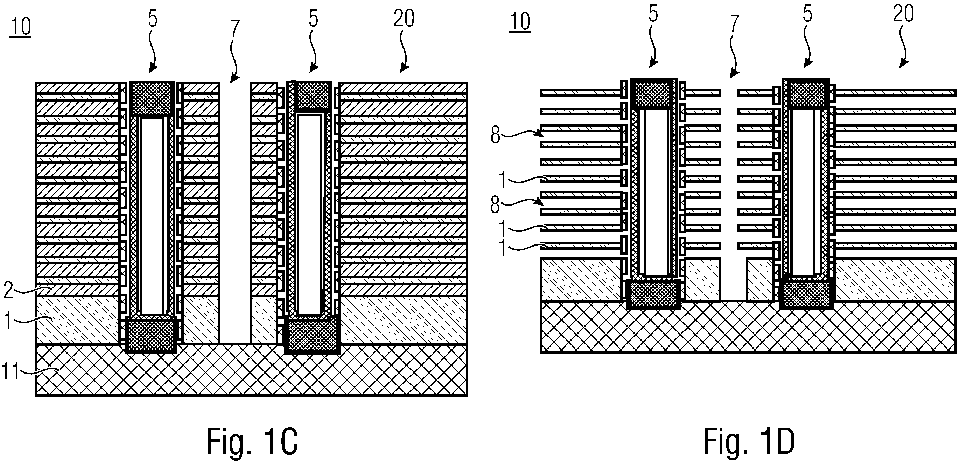

In Figur 1C ist zu sehen, dass in den vertikalen Ausnehmungen 6 Stützstrukturen 5 erzeugt werden. Die Stützstrukturen 5 sind mit den Einzelschichten 1, 2 mechanisch verbunden und stabilisieren die Einzelschichten 1, 2. Zwischen den beiden Stützstrukturen 5 wird eine zweite vertikale Ausnehmung 7 in den Schichtstapel 20 strukturiert. Durch diese zweite vertikale Ausnehmung 7 werden die Einzelschichten 1, 2 lateral freigelegt, sodass die Einzelschichten 1, 2 innerhalb der zweiten vertikalen Ausnehmung 7 frei zugänglich sind.

Im Zuge eines nasschemischen Ätzprozesses (Figur 1D) kann heiße Phosphorsäure durch die zweite vertikale Ausnehmung 7 in den Schichtstapel 20 eindringen. Dadurch gelangt die heiße Phosphorsäure zu den freigelegten Einzelschichten 1, 2 und ätzt hier selektiv die Siliziumnitrid-Einzelschichten 2 heraus, sodass nur die Siliziumoxid-Einzelschichten 1 bestehen bleiben. Zwischen den Siliziumoxid-Einzelschichten 1 entstehen an den Stellen, wo zuvor die Siliziumnitrid-Einzelschichten 2 waren, Leerräume 8.

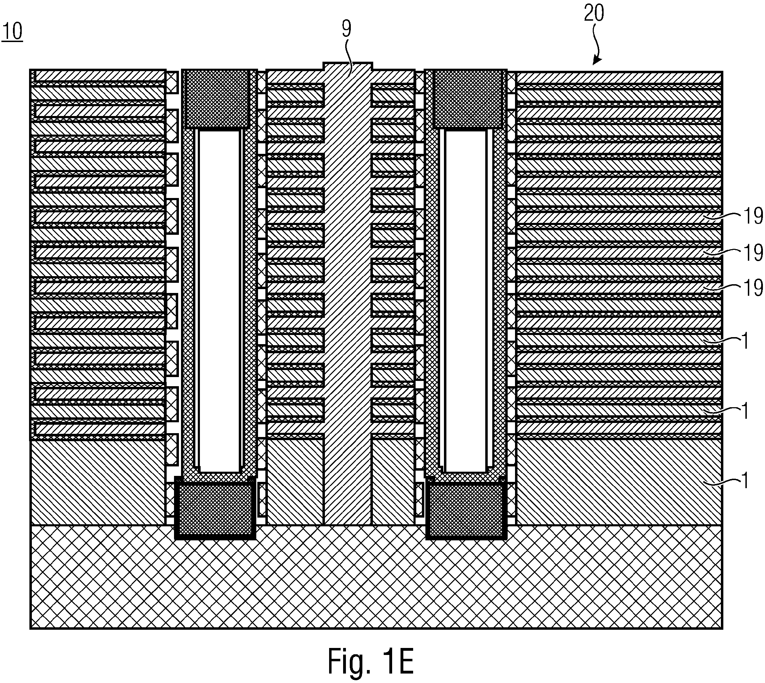

Wie in Figur 1E zu sehen ist, werden diese Leerräume 8 dann mit Wolfram 9 aufgefüllt. Im Ergebnis entsteht ein vertikaler Schichtstapel 20, der abwechselnd übereinander angeordnete Siliziumoxid-Einzelschichten 1 sowie Wolfram-Einzelschichten 19 aufweist.

Wie eingangs bereits erwähnt wurde, ist es ein Bestreben in der Herstellung von 3D NAND Speicherzellen, deren Speicherkapazität pro Volumen zu erhöhen. Dies wird unter anderem dadurch erreicht, dass immer mehr Einzelschichten aus Siliziumnitrid (Si₃N4₄) und Siliziumoxid (SiO₂) abwechselnd übereinander gestapelt werden, wodurch aber natürlich auch die Höhe des vertikalen Schichtstapels 20 insgesamt zunimmt. Um alle Siliziumnitrid-Einzelschichten 2 lateral ätzen zu können, wird die zweite vertikale Ausnehmung 7, wie zuvor erwähnt, in den Schichtstapel 20 eingebracht. Durch die zweite vertikale Ausnehmung 7 gelangt heiße Phosphorsäure zu den, innerhalb der zweiten vertikalen Ausnehmung 7 jeweils freigelegten und zugänglich gemachten, Siliziumnitrid-Einzelschichten 2. Mit zunehmender Höhe des Schichtstapels 20 muss aber natürlich auch das Aspektverhältnis der zweiten vertikalen Ausnehmung 7 entsprechend vergrößert werden. Mit zunehmendem Aspektverhältnis (aktuell z.B. 50:1) wird es jedoch immer schwieriger, mit der nasschemischen Ätzlösung eine homogene Ätzrate von Si₃N₄ selektiv zu SiO₂ entlang der zweiten vertikalen Ausnehmung 7 zu erzielen.

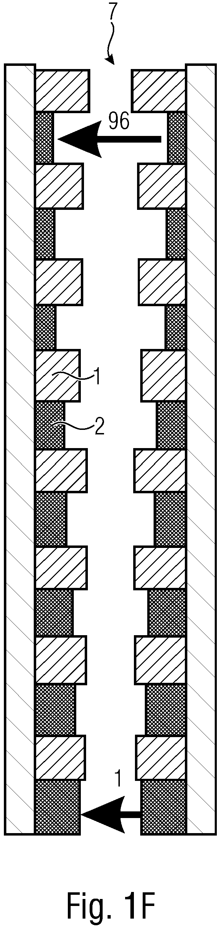

Figur 1F veranschaulicht dieses Problem. Hier ist, rein schematisch, ein Ausschnitt einer zweiten vertikalen Ausnehmung 7 innerhalb eines Schichtstapels mit mehreren, abwechselnd übereinander angeordneten, Einzelschichten 1, 2 abgebildet. Hierbei handelt es sich um Siliziumoxid-Schichten 1 und Siliziumnitrid-Schichten 2. Die Siliziumnitrid-Schichten 2 werden selektiv zu den Siliziumoxid-Schichten 1 weggeätzt. Hierzu wird heiße Phosphorsäure eingesetzt, die sich in vertikaler Richtung (in Figur 1F von oben nach unten) innerhalb der zweiten vertikalen Ausnehmung 7 ausbreitet.

Wie in Figur 1F zu sehen ist, werden die am unteren Ende der zweiten vertikalen Ausnehmung 7 befindlichen Einzelschichten 1, 2 im Vergleich zu den am oberen Ende der zweiten vertikalen Ausnehmung 7 befindlichen Einzelschichten 1, 2 deutlich weniger in lateraler Richtung weggeätzt. Mit der eingesetzten heißen Phosphorsäure kommt es also zu einer inhomogenen Ätzrate beim selektiven Ätzen der Siliziumnitrid-Schichten 2 relativ zu den Siliziumoxid-Schichten 1. Dieser Effekt tritt im Übrigen auch bei anderen nasschemischen Ätzlösungen sowie bei anderen Materialien der Einzelschichten 1, 2 auf.

Das daraus resultierende Problem ist eine Begrenzung der Anzahl der Einzelschichten innerhalb des Schichtstapels und der damit verbundenen Limitierung der Speicherkapazität. Das heißt, die zweite vertikale Ausnehmung 7 kann nicht beliebig tief ausgeführt werden, da es ansonsten zu immer deutlicher ausgeprägten inhomogenen Ätzraten kommt. Heutzutage können etwa bis zu 96 Einzelschichten mit dieser Technik lateral weggeätzt werden. Somit ist die Anzahl von Einzelschichten innerhalb eines Schichtstapels auf ebendiese 96 Einzelschichten begrenzt. Dies bedeutet jedoch auch, dass der Schichtstapel nicht wesentlich mehr Einzelschichten aufweisen darf, was jedoch die Speicherkapazität des Schichtstapels dementsprechend begrenzt.

Das hierin beschriebene neuartige Verfahren zum Herstellen von 3D Halbleiterspeichern ermöglicht es, die Ätzratenhomogenität beim selektiven lateralen Entfernen von Einzelschichten zu steigern, wodurch die Anzahl der Einzelschichten innerhalb eines Schichtstapels erhöht werden kann, um die Speicherkapazität des Halbleiterspeichers dementsprechend zu erhöhen.

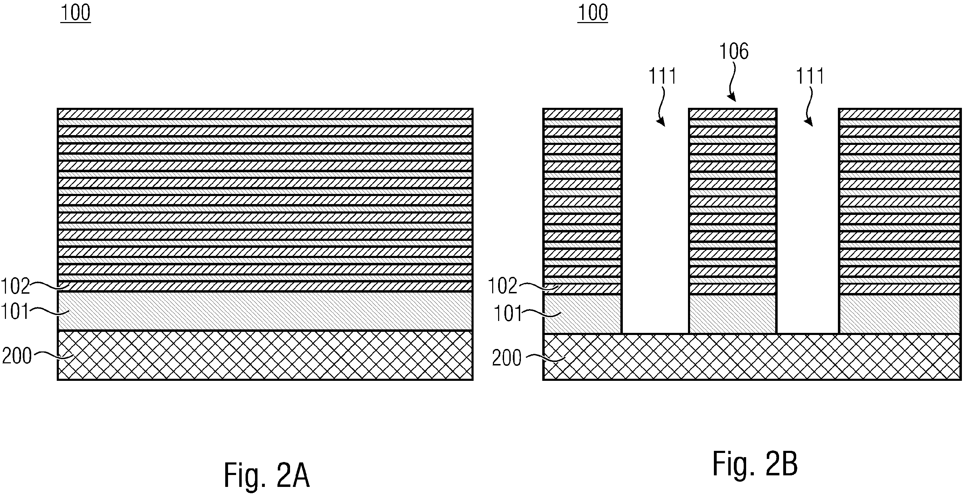

Die Figuren 2A bis 2K zeigen schematisch einzelne Verfahrensschritte des erfindungsgemäßen Verfahrens gemäß einem ersten Aspekt.

Figur 2A zeigt einen vertikalen beziehungsweise dreidimensionalen Schichtstapel 100. Der Schichtstapel 100 ist auf einem Substrat 200 angeordnet. Auf dem Substrat 200 werden abwechselnd mehrere Einzelschichten 101 eines ersten Materialtyps sowie mehrere Einzelschichten 102 eines unterschiedlichen zweiten Materialtyps aufgetragen. Die Einzelschichten 101, 102 können beispielsweise übereinander abgeschieden, und beispielsweise epitaktisch aufgewachsen, werden.

Die Einzelschichten 101 des ersten Materialtyps können beispielsweise ein erstes Material aufweisen oder daraus bestehen. Die Einzelschichten 102 des zweiten Materialtyps können beispielsweise ein, von dem ersten Material unterschiedliches, zweites Material aufweisen oder daraus bestehen. Das erste und das zweite Material können unterschiedliche Eigenschaften aufweisen.

Die Materialtypen bzw. die Materialien der Einzelschichten 101, 102 können beispielswiese derart gewählt sein, dass diese eine sehr hohe Ätzselektivität relativ zueinander aufweisen. Beispielsweise können die Einzelschichten 101 des ersten Materialtyps einen Verbindungshalbleiter aufweisen oder aus einem solchen bestehen. Die Einzelschichten 102 des zweiten Materialtyps hingegen können einen Elementhalbleiter aufweisen oder aus einem solchen bestehen. Beispielsweise können die Einzelschichten 101 des ersten Materialtyps einen IV-IV-Verbindungshalbleiter, und insbesondere Germanium (Ge) oder Siliziumgermanium (SiGe), aufweisen oder aus Germanium bzw. Siliziumgermanium bestehen. Die Einzelschichten 102 des zweiten Materialtyps hingegen können Silizium (Si) aufweisen oder aus Silizium bestehen.

In dem in Figur 2A abgebildeten Beispiel ist eine Einzelschicht 101 des ersten Materialtyps (z.B. SiGe) als unterste bzw. erste Schicht auf dem Substrat 200 angeordnet. Auf diese erste Schicht werden dann abwechselnd weitere Einzelschichten 102 des zweiten Materialtyps sowie weitere Einzelschichten 101 des ersten Materialtyps angeordnet. Dadurch ergibt sich ein vertikaler Schichtstapel 100 mit mehreren abwechselnd übereinander angeordneten Einzelschichten 101, 102 des ersten und zweiten Materialtyps. Die Reihenfolge der Einzelschichten 101, 102 kann aber auch vertauscht sein, sodass beispielsweise eine Einzelschicht 102 des zweiten Materialtyps als erste Schicht auf dem Substrat 200 angeordnet wird.

Figur 2B zeigt einen weiteren Prozessschritt. Hier werden ein oder mehrere vertikale Ausnehmungen 111 in dem Schichtstapel 100 erzeugt. Da mehrere vertikale Ausnehmungen erzeugt werden können, werden diese vertikalen Ausnehmungen 111 auch als erste vertikale Ausnehmungen bezeichnet.

Diese ersten vertikalen Ausnehmungen 111 werden in den Substratstapel 100 strukturiert, vorzugsweise mittels eines geeigneten Ätzverfahrens. Die ersten vertikalen Ausnehmungen 111 erstrecken sich von oben nach unten, d.h. von einer dem Substrat 200 entfernten Seite bzw. Oberfläche 106 des Schichtstapels 100 ausgehend vertikal nach unten in Richtung des Substrats 200. Die ersten vertikalen Ausnehmungen 111 erstrecken sich hierbei durch zumindest eine der Einzelschichten 101, 102, vorzugsweise durch mehrere Einzelschichten 101, 102, und weiter bevorzugt durch alle Einzelschichten 101, 102 des Schichtstapels 100 hindurch bis hinunter zum Substrat 200.

Die ersten vertikalen Ausnehmungen 111 bilden einen Zugang zu den jeweiligen Einzelschichten 101, 102 des Schichtstapels 100, in diesem Fall zu den im Schichtstapel 100 zu diesem Zeitpunkt vorhandenen Einzelschichten 101, 102 des ersten und zweiten Materialtyps. Das heißt, innerhalb der ersten vertikalen Ausnehmungen 111 werden die Einzelschichten 101, 102 abschnittsweise freigelegt, sodass die Einzelschichten 101, 102 über die ersten vertikalen Ausnehmungen 111 frei zugänglich sind.

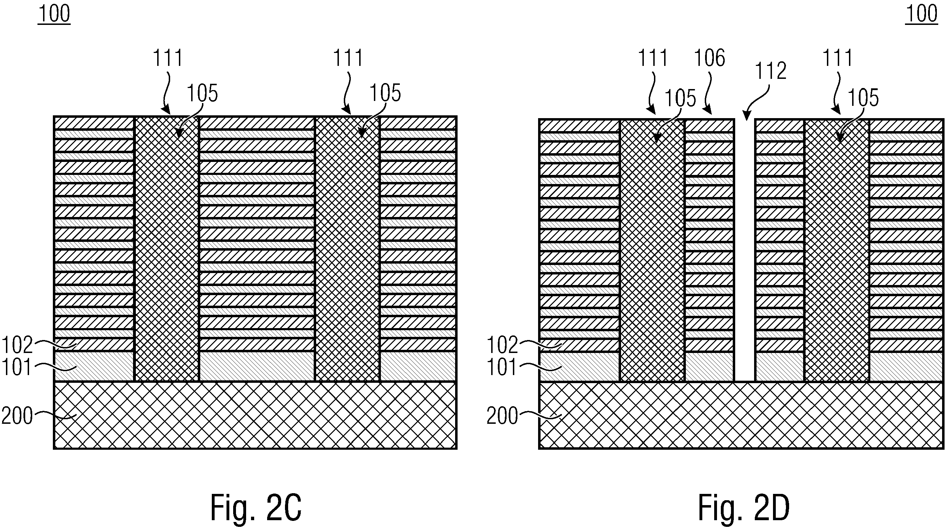

Wie in Figur 2C zu sehen ist, wird innerhalb der ersten vertikalen Ausnehmungen 111 jeweils eine Stützstruktur 105 erzeugt. Diese Stützstruktur 105 ist mit den jeweiligen Einzelschichten 101, 102 verbunden, um diese mechanisch zu stabilisieren bzw. zu stützen.

Zum Erzeugen einer Stützstruktur 105 kann mindestens eine der ersten vertikalen Ausnehmungen 111 mit einem Schichtsystem belegt bzw. gefüllt werden, welches das Kanalgebiet und die Isolatoren für das Gate und den Ladungsspeicher der späteren NAND-Speicherzelle bilden. Zur Belegung bzw. Füllung der ersten vertikalen Ausnehmungen 111 werden Schichten verwendet um die Isolatoren und Kanal-Region des NAND-Speichers zu erzeugen (Gateisolator/Speicher und Kanal-Komponenten). Das zur Belegung bzw. Befüllung verwendete Material kann beispielsweise ein oder mehrere Komponenten aus der Gruppe von Siliziumoxid, Siliziumnitrid und Silizium aufweisen. Eine denkbare Schichtfolge kann sein (von innen nach außen): Siliziumoxid-Siliziumnitrid-Siliziumoxid-Silizium. Nach dem Befüllen kann die jeweilige erste vertikale Ausnehmung 111 durch Schichtabscheidungen verschlossen werden. Die Belegung und Befüllung zum Erzeugen der vertikal ausgerichteten NAND-Speicher-Schichten kann theoretisch auch in einer anderen der hierin beschriebenen vertikalen Ausnehmungen 111, 112, 113 erfolgen.

Figur 2D zeigt einen weiteren Prozessschritt. Hier wird mindestens eine zweite vertikale Ausnehmung 112 in den Schichtstapel 100 strukturiert, z.B. geätzt. Diese zweite vertikale Ausnehmung 112 erstreckt sich ebenfalls von oben nach unten, d.h. von einer dem Substrat abgewandten Seite 106 des Schichtstapels 100 ausgehend vertikal nach unten in Richtung des Substrats 200. Die zweite vertikale Ausnehmung 112 erstreckt sich außerdem durch zumindest eine der Einzelschichten 101, 102, vorzugsweise durch mehrere Einzelschichten 101, 102, und weiter bevorzugt durch alle Einzelschichten 101, 102 des Schichtstapels 100 hindurch bis hinunter zum Substrat 200.

Die zweite vertikale Ausnehmung 112 bildet einen Zugang zu den jeweiligen Einzelschichten 101, 102 des Schichtstapels 100, in diesem Fall zu den im Schichtstapel 100 zu diesem Zeitpunkt vorhandenen Einzelschichten 101, 102 des ersten und zweiten Materialtyps. Das heißt, mittels der zweiten vertikalen Ausnehmung 112 werden die jeweiligen Einzelschichten 101, 102 des ersten und zweiten Materialtyps innerhalb und entlang der zweiten vertikalen Ausnehmung 112 freigelegt und lateral zugänglich gemacht. Beispielsweise kann ein Ätzmedium durch die zweite vertikale Ausnehmung 112 in den Schichtstapel 100 einströmen und darin die jeweils zugänglich gemachten Einzelschichten 101, 102 des ersten und zweiten Materialtyps erreichen.

Diesbezüglich beinhaltet das erfindungsgemäße Verfahren einen Schritt des selektiven Entfernens der zugänglich gemachten Einzelschichten 101 des ersten Materialtyps unter Anwendung eines in lateraler Richtung gerichteten Trockenätzprozesses mittels eines Ätzgases. Dies ist ein wesentlicher Unterschied der vorliegenden Erfindung gegenüber den im Stand der Technik eingesetzten nasschemischen Ätzverfahren.

Aufgrund des erfindungsgemäß eingesetzten Trockenätzprozesseses zum selektiven Entfernen bestimmter Einzelschichten im Schichtstapel 100 kommt es nicht zu den eingangs erwähnten Benetzungsproblemen, wie dies bei nasschemischen Ätzverfahren der Fall ist. Folglich können die Einzelschichten 101 des ersten Materialtyps, im Vergleich zu konventionell eingesetzten Nassätzprozessen, mit einer deutlich gesteigerten Homogenität selektiv zu den Einzelschichten 102 des zweiten Materialtyps aus dem Schichtstapel 100 herausgeätzt werden.

Ein Trockenätzprozess kann bezüglich des Diffusionstransports viel besser optimiert werden als ein nasschemisches Verfahren. Der erfindungsgemäß eingesetzte Trockenätzprozess hat deutlich mehr Freiheitsgrade bei der Prozessoptimierung (z.B. größeres Temperaturfenster, variabler Prozessdruck, verschiedene Prozessgasflüsse,...). Mit diesen Möglichkeiten kann das selektive Herausätzen der Einzelschichten 101 des ersten Materialtyps hinsichtlich der Ätzratenhomogenität entlang der zweiten vertikalen Ausnehmung 112 im Speicherstapel 100 trotz immer weiter steigenden Aspektverhältnissen der vertikalen Ausnehmungen 112 optimiert werden.

Zur Durchführung des erfindungsgemäß eingesetzten Trockenätzprozesses kann der Schichtstapel 100 in eine Prozesskammer gegeben werden. Darin kann der Schichtstapel 100 mit bestimmten Prozessparametern und durch Zuführen von Ätzgas in die Prozesskammer in der hierin beschriebenen Art und Weise geätzt werden. Das Trockenätzen kann beispielsweise bei hoher Temperatur (ca. 600°C) mit einem entsprechenden Ätzgas bei niedrigem Druck durchgeführt werden.

Beispielsweise kann der Trockenätzprozess bei Temperaturen von über 350°C, oder aber auch bei Temperaturen von über 500°C ausgeführt werden. Das eingesetzte Ätzgas wiederum kann beispielsweise Chlorwasserstoff (HCl) enthalten oder aus Chlorwasserstoff bestehen. Das eingesetzte Ätzgas sollte auf die unterschiedlichen Materialtypen und/oder die verwendeten Materialien der jeweiligen Einzelschichten abgestimmt sein, sodass die Einzelschichten des einen Materialtyps höchst selektiv gegenüber den Einzelschichten des jeweils anderen Materialtyps aus dem Schichtstapel 100 herausgeätzt werden können. So eignet sich beispielsweise HCI-Gas sehr gut zum selektiven Herausätzen von Einzelschichten 101 aus Siliziumgermanium unter Beibehaltung von Einzelschichten 102 aus reinem Silizium.

Zum selektiven Herausätzen bestimmter Einzelschichten gelangt das während des Trockenätzprozesses in die Prozesskammer eingeleitete Ätzgas durch die zweite vertikale Ausnehmung 112 hindurch zunächst an die darin abschnittsweise freigelegten Einzelschichten 101, 102 des ersten und des zweiten Materialtyps des Schichtstapels 100. Die beiden Materialtypen weisen aber, in Kombination mit dem eingesetzten Ätzgas, eine sehr hohe Ätzselektivität relativ zueinander auf. Mittels dem eingesetzten Ätzgas können demnach die Einzelschichten des einen Materialtyps sehr selektiv gegenüber den Einzelschichten des jeweils anderen Materialtyps entfernt werden.

Beispielsweise kann das Ätzgas die Einzelschichten 101 des ersten Materialtyps selektiv zu den Einzelschichten 102 des zweiten Materialtyps herausätzen, und zwar vorzugsweise in einer lateralen Richtung. Unter einer lateralen Richtung ist eine Richtung zu verstehen, die im Wesentlichen orthogonal zur (vertikalen) Schichtrichtung des Schichtstapels 100 verläuft. Die Schichtrichtung ist die Richtung in der die Einzelschichten 101 ,102 übereinander gestapelt werden, im vorliegenden Fall also beispielsweise vom Substrat 200 ausgehend vertikal nach oben. Die laterale Richtung wäre in diesem Fall beispielsweise eine etwa horizontale Richtung. Dementsprechend können die Einzelschichten 101 des ersten Materialtyps, von der zweiten vertikalen Ausnehmung 112 ausgehend, in etwa horizontaler Richtung aus dem Schichtstapel 100 herausgeätzt werden. Die Einzelschichten 102 des zweiten Materialtyps werden hingegen nicht wesentlich von dem eingesetzten Ätzgas angegriffen und werden somit nicht herausgeätzt, sondern sie verbleiben im Schichtstapel 100.

Das Ätzgas, das durch die zweite vertikale Ausnehmung 112 in den Schichtstapel 100 gelangt, entfernt dort also die Einzelschichten des einen Materialtyps selektiv gegenüber den Einzelschichten des jeweils anderen Materialtyps. Beispielsweise kann das eingesetzte Ätzgas die Einzelschichten 101 des ersten Materialtyps in lateraler Richtung aus dem Schichtstapel 100 herausätzen. Die Einzelschichten 101 des ersten Materialtyps werden dabei selektiv zu den Einzelschichten 102 des zweiten Materialtyps aus dem Schichtstapel 100 herausgeätzt. Das heißt, nach dem selektiven Entfernen der Einzelschichten 101 des ersten Materialtyps verbleiben lediglich die Einzelschichten des zweiten Materialtyps 102 in dem Schichtstapel.

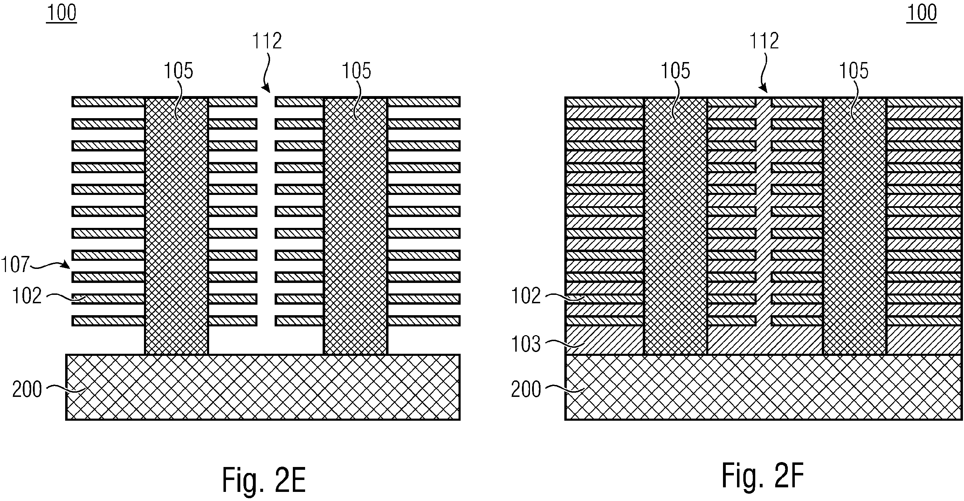

Figur 2E zeigt den nach dem selektiven Herausätzen der Einzelschichten 101 des ersten Materialtyps entstehenden Schichtstapel 100. Dabei bleiben lediglich die Einzelschichten 102 des zweiten Materialtyps übrig. Zwischen den verbleibenden Einzelschichten 102 des zweiten Materialtyps entstehen, an den Stellen wo zuvor die mittlerweile entfernten Einzelschichten 101 des ersten Materialtyps waren, Leerräume 107. Die verbleibenden Einzelschichten 102 des zweiten Materialtyps stützen sich an den Stützstrukturen 105 ab. Die Stützstrukturen 105 wiederum sind mit dem Substrat 200 verbunden.

Figur 2F zeigt einen weiteren Prozessschritt. Hier werden Einzelschichten 103 eines dritten Materialtyps erzeugt. Hierfür kann beispielsweise in die zwischen den Einzelschichten 102 des verbleibenden zweiten Materialtyps entstandenen Leerräume 107 ein drittes Material eingebracht werden. Dabei bilden sich innerhalb dieser Leerräume 107 zwischen den verbleibenden Einzelschichten 102 des zweiten Materialtyps jeweils Einzelschichten 103 des dritten Materialtyps. Dadurch entsteht ein vertikaler Schichtstapel 100 mit abwechselnd übereinander angeordneten Einzelschichten 102 des zweiten Materialtyps und Einzelschichten 103 des dritten Materialtyps.

Die Einzelschichten 103 des dritten Materialtyps können beispielsweise ein, von dem ersten Material und/oder dem zweiten Material unterschiedliches, drittes Material aufweisen oder daraus bestehen. Das dritte Material kann, im Vergleich zu dem ersten und/oder zweiten Material, unterschiedliche Eigenschaften aufweisen. Beispielsweise kann das dritte Material elektrisch isolierende Eigenschaften aufweisen. Das dritte Material kann beispielsweise Silizium(di-)oxid (SiO₂) aufweisen oder aus Silizium(di-)oxid bestehen. Dementsprechend können also beispielsweise die Einzelschichten 103 des dritten Materialtyps elektrisch isolierende Eigenschaften aufweisen. Die Einzelschichten 102 des zweiten Materialtyps hingegen können elektrisch leitfähige Eigenschaften aufweisen.

Das Einbringen des dritten Materials in die Leerräume 107 zwischen den bestehenbleibenden Einzelschichten 102 des zweiten Materialtyps kann beispielsweise mittels eines additiven Trockenprozesses, vorzugsweise aus der Gasphase, ausgeführt werden. Beispielsweise kann das dritte Material unter Anwendung eines LPCVD-Prozesses (LPCVD: Low Pressure Chemical Vapor Deposition) in die Leerräume 107 eingebracht werden.

Hierbei kann ein Prozessgas in die Prozesskammer (in der sich der Schichtstapel 100 befindet) eingeleitet werden. Das Prozessgas erreicht über die zweite vertikale Ausnehmung 112 die Leerräume 107 zwischen den Einzelschichten 102 des zweiten Materialtyps und breitet sich darin aus. Das Auftreffen der Gasmoleküle des Prozessgases auf den Einzelschichten 102 des zweiten Materialtyps führt dazu, dass in den Leeräumen 107 das dritte Material (z.B. SiO₂) zwischen den bestehenbleibenden Einzelschichten 102 des zweiten Materialtyps (z.B. Si) aufwächst. Dadurch bilden sich die Einzelschichten 103 des dritten Materialtyps zwischen den Einzelschichten 102 des zweiten Materialtyps.

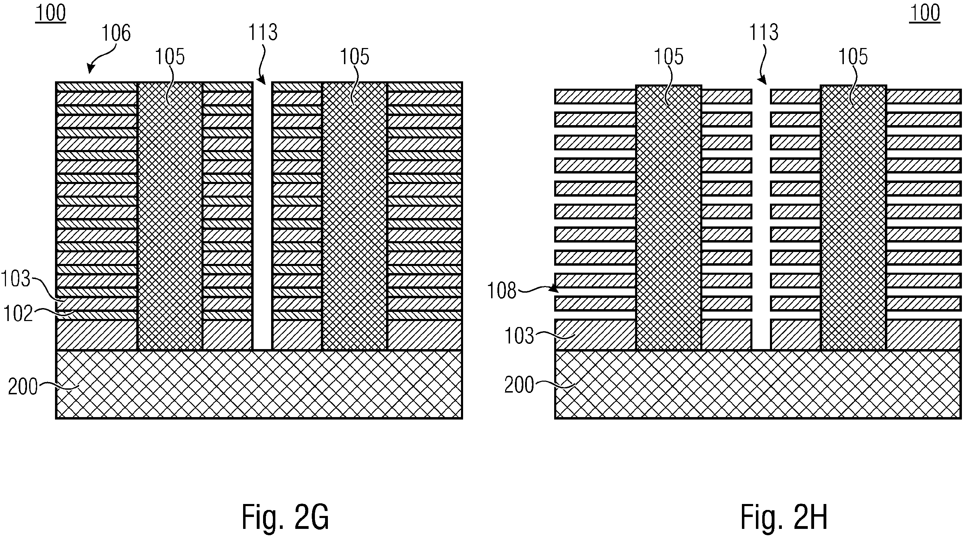

Figur 2G zeigt einen weiteren Prozessschritt. Hier wird mindestens eine dritte vertikale Ausnehmung 113 in den Schichtstapel 100 strukturiert. Hierbei kann beispielsweise die mit dem dritten Material gefüllte zweite vertikale Ausnehmung 112 (Figur 2F) wieder freigelegt werden, um an derselben Stelle die dritte vertikale Ausnehmung 113 (Figur 2G) zu erzeugen. Alternativ kann die mit dem dritten Material gefüllte zweite vertikale Ausnehmung 112 (Figur 2F) verschlossen bleiben und an einer anderen Stelle im Schichtstapel 100 die dritte vertikale Ausnehmung 113 erzeugt werden. Die dritte vertikale Ausnehmung 113 kann, wie beispielhaft in Figur 2G gezeigt ist, zwischen zwei Stützstrukturen 105 erzeugt werden.

Die dritte vertikale Ausnehmung 113 erstreckt sich ebenfalls von oben nach unten, d.h. von einer dem Substrat 200 abgewandten Seite 106 des Schichtstapels 100 ausgehend vertikal nach unten in Richtung des Substrats 200. Die dritte vertikale Ausnehmung 113 erstreckt sich außerdem durch zumindest eine der Einzelschichten 102, 103, vorzugsweise durch mehrere Einzelschichten 102, 103, und weiter bevorzugt durch alle Einzelschichten 102, 103 des Schichtstapels 100 hindurch bis hinunter zum Substrat 200.

Die dritte vertikale Ausnehmung 113 bildet einen Zugang zu den jeweiligen Einzelschichten 102, 103 des Schichtstapels 100, in diesem Fall zu den im Schichtstapel 100 zu diesem Zeitpunkt vorhandenen Einzelschichten 102, 103 des zweiten und dritten Materialtyps. Diese Einzelschichten 102, 103 des zweiten und dritten Materialtyps werden demnach innerhalb der dritten vertikalen Ausnehmung 113 freigelegt und über die dritte vertikale Ausnehmung 113 zugänglich gemacht.

Das erfindungsgemäße Verfahren beinhaltet ferner ein selektives Entfernen der zugänglich gemachten Einzelschichten des einen Materialtyps relativ zu den Einzelschichten des jeweils anderen Materialtyps. Im vorliegenden Fall beinhaltet das Verfahren ein selektives Entfernen der Einzelschichten 102 des zweiten Materialtyps selektiv zu den Einzelschichten 103 des dritten Materialtyps. Dieses selektive Entfernen geschieht unter Anwendung eines in lateraler Richtung gerichteten Ätzprozesses mittels eines Ätzmediums. Der Ätzprozess kann dabei erneut ein Trockenätzprozess, aber alternativ auch ein Nassätzprozess, sein. Das Ätzmedium kann bei diesem Ätzschritt dementsprechend ein Ätzgas zum Trockenätzen, z.B. ein ionisiertes Ätzgas bzw. Plasma wie bei einer Plasmaätzung, oder eine nasschemische Ätzlösung zum Nassätzen sein.

Im Falle eines Trockenätzprozesses kann dieser mindestens einen plasmaunterstützten Ätzschritt mit einem fluorhaltigen Gas beinhalten. Das Trockenätzen kann beispielsweise als isotroper CDE-Prozess (CDE: Chemical Dry Etching) mit einem fluorhaltigen Gas ausgeführt werden, wodurch beispielsweise Silizium (als denkbares Material der Einzelschichten 102) sehr selektiv zu SiO₂ (als denkbares Material der Einzelschichten 103) geätzt werden kann. Als Ätzgas kann beispielsweise SF₆ eingesetzt werden. Insbesondere Plasmaätzungen mit einem hohen SF₆-Fluss, einem niedrigen O₂-Fluss und einem hohen Prozessdruck erlauben sehr selektive Ätzungen zwischen Si und SiO₂ mit einem isotropen Ätzverhalten, wie es für diese Ätzung gewünscht ist.

Das Ätzmedium (z.B. SF₆-Gas) gelangt durch die dritte vertikale Ausnehmung 113 hindurch zu den, innerhalb der dritten vertikalen Ausnehmung 113 freigelegten und zugänglich gemachten, Einzelschichten 102, 103 des zweiten und dritten Materialtyps. Dabei entfernt das Ätzmedium die Einzelschichten 102 des zweiten Materialtyps in lateraler Richtung selektiv zu den Einzelschichten 103 des dritten Materialtyps, sodass nach dem selektiven Entfernen der Einzelschichten 102 des zweiten Materialtyps lediglich die Einzelschichten 103 des dritten Materialtyps verbleiben. Das heißt, die Einzelschichten 102 des zweiten Materialtyps werden aus dem Schichtstapel 100 herausgeätzt.

Figur 2H zeigt einen, nach dem selektiven Herausätzen der Einzelschichten 102 des zweiten Materialtyps, entstehenden Schichtstapel 100. Dabei bleiben lediglich die Einzelschichten 103 des dritten Materialtyps übrig. Zwischen den verbleibenden Einzelschichten 103 des dritten Materialtyps entstehen, an den Stellen wo zuvor die mittlerweile entfernten Einzelschichten 102 des zweiten Materialtyps waren, Leerräume 108. Die verbleibenden Einzelschichten 103 des dritten Materialtyps stützen sich an den Stützstrukturen 105 ab.

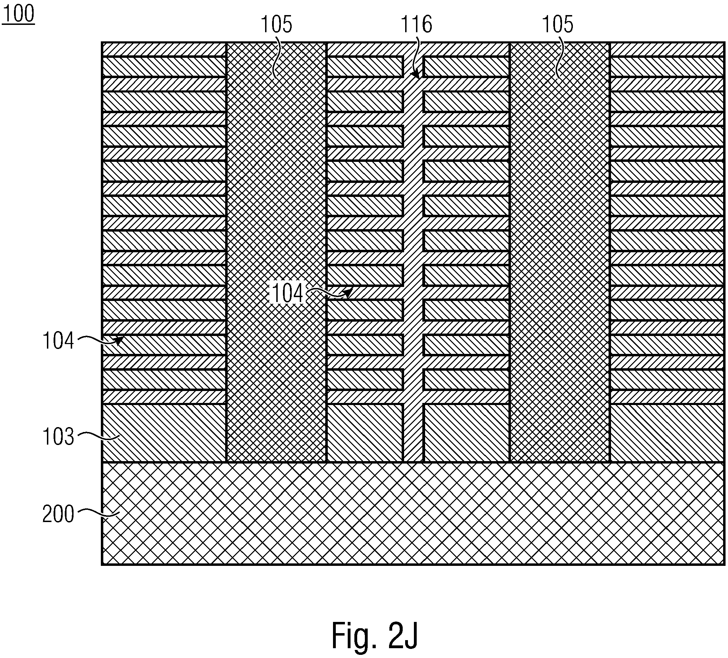

Figur 2J zeigt einen optionalen weiteren Prozessschritt. In die zwischen den Einzelschichten 103 des verbleibenden dritten Materialtyps entstandenen Leerräume 108 kann ein viertes Material eingebracht werden. Dabei bilden sich innerhalb dieser Leerräume 108 zwischen den verbleibenden Einzelschichten 103 des dritten Materialtyps jeweils Einzelschichten 104 des vierten Materialtyps. Dadurch entsteht ein vertikaler Schichtstapel 100 mit abwechselnd übereinander angeordneten Einzelschichten 103 des dritten Materialtyps und Einzelschichten 104 des vierten Materialtyps.

Das vierte Material kann unterschiedlich zu dem dritten Material sein. Das vierte Material kann ein elektrisch leitfähiges Metall, und insbesondere ein hochleitfähiges Metall, aufweisen oder daraus bestehen. Beispielsweise kann das vierte Material mindestens eine Komponente aus der Gruppe von Wolfram, Kobalt, Molybdän oder Ruthenium aufweisen oder aus ebendieser Komponente bestehen.

Alternativ dazu kann das vierte Material einen dotierten Halbleiter aufweisen oder daraus bestehen. Beispielsweise kann das vierte Material dotiertes Silizium aufweisen.

Aufgrund des zuvor beschriebenen Befüllens der vertikalen Ausnehmung 113 (Figur 2H) mit dem vierten Material, entsteht an dieser Stelle eine vertikal verlaufende Struktur 116, welche mit den jeweiligen Einzelschichten 103, 104 mechanisch sowie elektrisch verbunden ist.

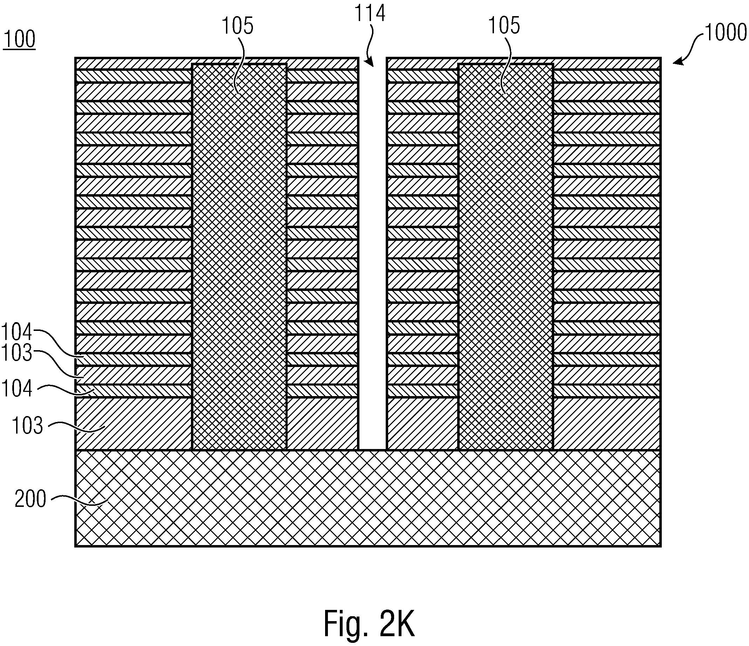

Wie in Figur 2K gezeigt ist, kann diese vertikale Struktur 116, z.B. mittels eines geeigneten Ätzprozesses, entfernt werden, sodass die Einzelschichten 103, 104 (und insbesondere die elektrisch leitfähigen Einzelschichten 104 des vierten Materialtyps) nicht mehr jeweils untereinander mechanisch bzw. elektrisch verbunden sind. Es kann also sozusagen eine vierte vertikale Ausnehmung 114 in dem Schichtstapel 100 erzeugt werden, beispielsweise zwischen den Stützstrukturen 105. Diese vierte vertikale Ausnehmung 114 kann die elektrische Verbindung (in lateraler bzw. horizontaler Richtung gesehen) zwischen den zuvor miteinander verbundenen einzelnen Einzelschichten 103 des dritten Materialtyps sowie zwischen den zuvor miteinander verbundenen einzelnen Einzelschichten 104 des vierten Materialtyps unterbrechen.

Somit können die Einzelschichten 104 des vierten Materialtyps jeweils eine Word Line des erzeugten dreidimensional-integrierten Halbleiterspeichers 1000 bilden.

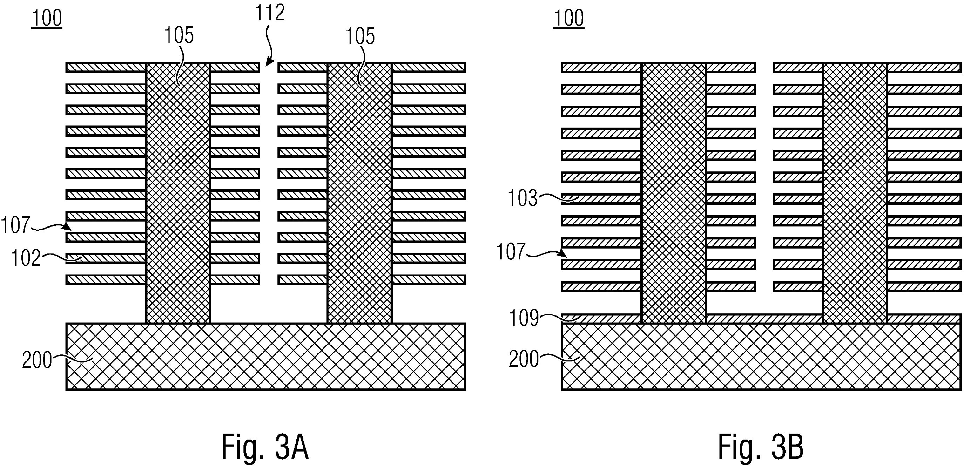

Die Figuren 3A bis 3D zeigen eine Alternativlösung zu den bisher beschriebenen Verfahrensschritten zum Herstellen eines dreidimensional-integrierten Halbleiterspeichers. Das heißt, bei dem im Nachfolgenden beschriebenen Verfahren handelt es sich um eine Alternativlösung für die selbe objektive technische Aufgabe.

Bei dieser Alternativlösung sind die Verfahrensschritte, die zuvor unter Bezugnahme auf die Figuren 2A bis 2E beschrieben wurden, gleich. Somit gelten auch bei dieser Alternativlösung alle obigen Ausführungen dementsprechend.

Figur 3A zeigt zunächst noch einmal die Ausgangssituation des Schichtstapels 100 wie er auch in Figur 2E gezeigt ist und bis zu diesem Verfahrensschritt entsteht. Hier weist also der zu diesem Zeitpunkt vorhandene Schichtstapel 100 zunächst nur die Einzelschichten 102 des zweiten Materialtyps auf. Zwischen diesen Einzelschichten 102 des zweiten Materialtyps sind Leerräume 107 vorhanden.

Die Einzelschichten 102 des zweiten Materialtyps stützen sich an den Stützstrukturen 105 ab und zwischen den Stützstrukturen 105 befindet sich die zweite vertikale Ausnehmung 112. Während nun in der zuvor, unter Bezugnahme auf die Figuren 2F bis 2K, beschriebenen Ausführungsform ein drittes Material in die Leerräume 107 eingebracht wurde, um die Einzelschichten 103 des dritten Materialtyps zu erzeugen, werden nun in dieser alternativen Ausführungsform stattdessen die Einzelschichten 103 des dritten Materialtyps aus den Einzelschichten 102 des zweiten Materialtyps erzeugt.

Wie in Figur 3B zu sehen ist, werden die Einzelschichten 103 des dritten Materialtyps an den Stellen im Schichtstapel 100 erzeugt, an denen sich zuvor die Einzelschichten 102 des zweiten Materialtyps befanden. Hierbei werden dementsprechend auch die Leerräume 107 an ihren vorherigen Stellen beibehalten, die sich somit zwischen den neu gebildeten Einzelschichten 103 des dritten Materialtyps befinden.

Das Erzeugen der Einzelschichten 103 des dritten Materialtyps aus den Einzelschichten 102 des zweiten Materialtyps kann beispielsweise mittels einer Oxidation erfolgen. Hierbei können beispielsweise die Einzelschichten 102 des zweiten Materialtyps zumindest teilweise oxidiert werden, sodass die Einzelschichten 102 des zweiten Materialtyps aufgrund der aufgewachsenen Oxide ihre Eigenschaften, d.h. ihren Materialtypus, ändern. Dadurch werden also aus den Einzelschichten 102 des zweiten Materialtyps die Einzelschichten 103 des dritten Materialtyps erzeugt. Anders ausgedrückt können die Einzelschichten 103 des dritten Materialtyps dadurch erzeugt werden, dass die Einzelschichten 102 des zweiten Materialtyps umgewandelt werden und dabei ihren Materialtypus ändern. Somit befinden sich dementsprechend die Einzelschichten 103 des dritten Materialtyps nun an den Stellen im Schichtstapel 100, an denen sich zuvor die Einzelschichten 102 des zweiten Materialtyps befanden. Außerdem kann sich während der Oxidation eine Oxidschicht auf dem Substrat 200 anlagern.

Beispielsweise können die Einzelschichten 102 des zweiten Materialtyps Silizium aufweisen oder aus Silizium bestehen. Diese Einzelschichten 102 können dann mittels einer thermischen Oxidation zu Silizium(di)oxid SiO₂ umgewandelt werden, sodass die dabei erzeugten Einzelschichten 103 des dritten Materialtyps Silizium(di)oxid aufweisen.

Anstelle der thermischen Oxidation von Silizium zu Siliziumoxid sieht ein weiteres (hier nicht explizit dargestelltes) Ausführungsbeispiel vor, dass die Einzelschichten 102 des zweiten Materialtyps mit einem Beschichtungsmaterial belegt werden, z.B. unter Anwendung eines Beschichtungsverfahrens. Die Einzelschichten 102 des zweiten Materialtyps können beispielsweise vollständig und vollumfänglich mit dem Beschichtungsmaterial belegt werden, und so von dem Beschichtungsmaterial umhüllt sein. Das Beschichtungsmaterial kann Eigenschaften aufweisen, die sich von den Eigenschaften des zweiten Materialtyps unterscheiden. Beispielsweise kann das Beschichtungsmaterial einen dritten Materialtyp aufweisen, der sich von dem zweiten Materialtyp unterscheidet.

Dadurch ändern sich natürlich auch die Eigenschaften der mit ebendiesem Beschichtungsmaterial belegten Einzelschichten 102 des zweiten Materialtyps, d.h. der Materialtyp der Einzelschichten 102 ändert sich. Somit können also die Einzelschichten 103 des dritten Materialtyps aus den Einzelschichten 102 des zweiten Materialtyps erzeugt werden, indem die Einzelschichten 102 des zweiten Materialtyps mit einem Beschichtungsmaterial belegt werden, das einen zu dem zweiten Materialtyp unterschiedlichen dritten Materialtyp aufweist. Oder anders ausgedrückt, die Einzelschichten 103 des dritten Materialtyps sind die mit dem Beschichtungsmaterial belegten Einzelschichten 102 des zweiten Materialtyps, wobei das Beschichtungsmaterial den dritten Materialtyp definiert. Die Einzelschichten 103 des dritten Materialtyps befinden sich somit an den Stellen im Schichtstapel 100, an denen sich zuvor die unbelegten Einzelschichten 102 des zweiten Materialtyps befanden.

Beispielsweise können die Einzelschichten 102 des zweiten Materialtyps einen Materialtyp mit elektrisch halbleitenden Eigenschaften aufweisen. Das Beschichtungsmaterial, das zur Belegung der Einzelschichten 102 verwendet wird, kann hingegen einen Materialtyp mit elektrisch isolierenden Eigenschaften aufweisen. Beispielsweise kann es sich bei dem Beschichtungsmaterial um ein Oxid oder ein Nitrid handeln. Dieses lagert sich an den elektrisch halbleitenden Einzelschichten 102 des zweiten Materialtyps an, sodass die Einzelschichten 102 nach der Belegung mit dem elektrisch isolierenden Material dementsprechend elektrisch isolierende Eigenschaften aufweisen und somit die Einzelschichten 103 des dritten Materialtyps bilden. Der Materialtyp ändert sich also in diesem Beispiel von elektrisch halbleitend (zweiter Materialtyp) zu elektrisch isolierend (dritter Materialtyp).

Im Ergebnis erhält man einen Schichtstapel 100, so wie er zuvor unter Bezugnahme auf Figur 2H beschrieben wurde. Dementsprechend gelten auch alle mit Bezug auf Figur 2H diskutierten Merkmale dementsprechend für den Verfahrensschritt wie er in Figur 3B abgebildet ist.

Es ist jedoch zu erkennen, dass hier im Wesentlichen zwei Prozessschritte, nämlich die in den Figuren 2F und 2G gezeigten Prozessschritte, vollständig entfallen können. Dies ist ein Vorteil dieser alternativen Ausführungsform.

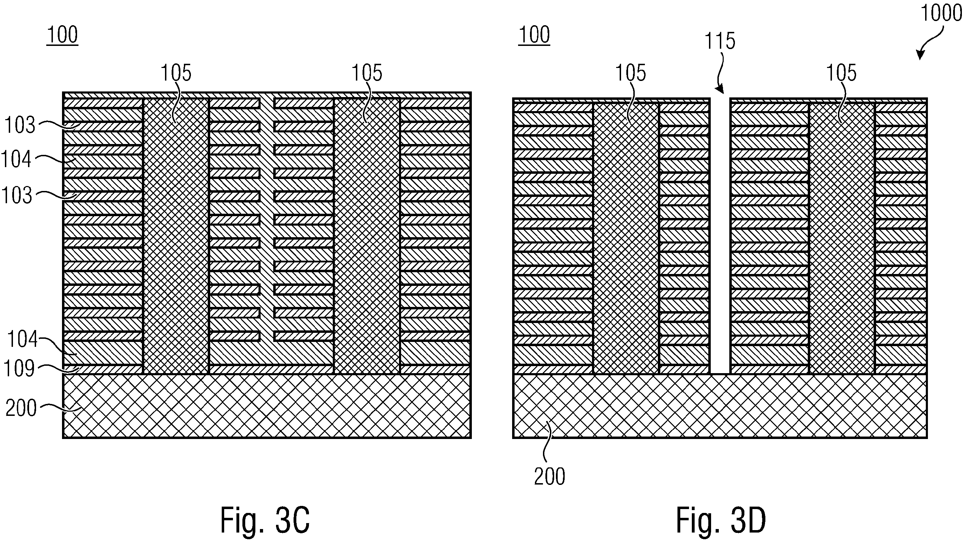

Figur 3C zeigt dann einen weiteren Prozessschritt. Dieser Schritt entspricht im Wesentlichen dem zuvor unter Bezugnahme auf Figur 2J beschriebenen Verfahrensschritt. Auch hier gelten dementsprechend alle Merkmale von Figur 2J ebenfalls für Figur 3C.

Hier werden die Leerräume 107, die zwischen den Einzelschichten 103 des dritten Materialtyps vorhanden waren (Figur 3B) mit einem vierten Material gefüllt. Dabei bilden sich innerhalb dieser Leerräume 107 zwischen den Einzelschichten 103 des dritten Materialtyps jeweils Einzelschichten 104 eines vierten Materialtyps. Dadurch entsteht ein vertikaler Schichtstapel 100 mit abwechselnd übereinander angeordneten Einzelschichten 103 des dritten Materialtyps und Einzelschichten 104 des vierten Materialtyps.

Das vierte Material kann unterschiedlich zu dem dritten Material (Beschichtungsmaterial) sein. Das vierte Material kann ein elektrisch leitfähiges Metall, und insbesondere ein hochleitfähiges Metall, aufweisen oder daraus bestehen. Beispielsweise kann das vierte Material mindestens eine Komponente aus der Gruppe von Wolfram, Kobalt, Molybdän oder Ruthenium aufweisen oder aus ebendieser Komponente bestehen.

Alternativ dazu kann das vierte Material einen dotierten Halbleiter aufweisen oder daraus bestehen. Beispielsweise kann das vierte Material dotiertes Silizium aufweisen.

Dementsprechend können die Einzelschichten 104 des vierten Materialtyps elektrisch leitfähige Eigenschaften aufweisen. Wie eingangs erwähnt, können die Einzelschichten 103 des dritten Materialtyps beispielsweise elektrisch isolierende Eigenschaften aufweisen. Der dritte und vierte Materialtyp können also unterschiedliche Eigenschaften aufweisen.

Figur 3D zeigt einen weiteren Prozessschritt, der im Wesentlichen dem zuvor unter Bezugnahme auf Figur 2K diskutierten Prozessschritt entspricht. Auch hier gelten dementsprechend alle Merkmale von Figur 2K ebenfalls für Figur 3D. Auch hier kann, beispielsweise zwischen den Stützstrukturen 105, eine vierte vertikale Ausnehmung 114 in den Schichtstapel 100 strukturiert werden. Diese vierte vertikale Ausnehmung 114 kann, z.B. mittels eines geeigneten Ätzprozesses, in den Schichtstapel 100 strukturiert werden, sodass die Einzelschichten 103, 104 (und insbesondere die elektrisch leitfähigen Einzelschichten 104 des vierten Materialtyps) nicht mehr untereinander mechanisch bzw. elektrisch verbunden sind, so wie es zuvor unter Bezugnahme auf Figur 2K beschrieben wurde.

Somit können die Einzelschichten 104 des vierten Materialtyps jeweils eine Word Line des erzeugten dreidimensional-integrierten Halbleiterspeichers 1000 bilden.

Am Ende der bisher beschriebenen Prozessschritte beider Verfahren entsteht ein dreidimensional-integrierter Halbleiterspeicher 1000. Hierbei kann es sich insbesondere um einen 3D NAND Flash Speicher handeln.

Die Gate-NAND-Struktur kann in einer der Stützstrukturen 105 integriert werden, oder nach dem Füllen des Schichtstapels mit dem vierten Material (z.B. Wolfram) durch Erzeugen einer weiteren vertikalen Ausnehmung im Schichtstapel 100 und Belegung dieser weiteren vertikalen Ausnehmung mit entsprechenden Schichten.

Für das hierin beschriebene erfindungsgemäße Verfahren hat es sich als besonders vorteilhaft herausgestellt, wenn die Einzelschichten 101 des ersten Materialtyps Germanium (Ge) oder Siliziumgermanium (SiGe) aufweisen oder daraus bestehen. Ge bzw. SiGe kann sehr präzise mittels Trockenätzverfahren, insbesondere unter Anwendung von HCl-Gas, geätzt werden, und es weist zudem eine sehr hohe Selektivität gegenüber z.B. Silizium (als Material der Einzelschichten 102) auf.

Es ist jedoch durchaus denkbar, dass die Einzelschichten 101 des ersten Materialtyps anstelle von Germanium bzw. Siliziumgermanium andere Materialien aufweisen bzw. aus anderen Materialien bestehen. Entscheidend hierbei ist, dass der erste Materialtyp eine hohe Ätzselektivität gegenüber dem zweiten Materialtyp aufweist. Dies kann beispielsweise dadurch erreicht werden, dass das erste Material (welches für die Einzelschichten 101 des ersten Materialtyps verwendet wird) eine hohe Selektivität gegenüber dem zweiten Material (welches für die Einzelschichten 102 des zweiten Materialtyps verwendet wird) aufweist und mittels eines geeigneten Gases selektiv zu ebendiesem zweiten Material, unter Anwendung eines Trockenätzprozesses, aus dem Schichtstapel 100 herausgeätzt werden kann.

Zusammenfassend beschreibt die vorliegende Erfindung ein Verfahren, das es ermöglicht einen Schichtstapel 100, der z.B. leitfähige Materialschichten zwischen Isolatorschichten enthält, ausschließlich mithilfe von Trockenätzprozessen zu erzeugen.

In anderen Worten wird ein Verfahren zur Herstellung eines Schichtstapels 100 in einem Halbleiter-Speicher 1000 bereitgestellt. Das Verfahren weist ein Bereitstellen eines Substrats 200 auf, sowie einen Schritt des Aufbringens von mindestens einer ersten Schicht 101 auf das Substrat 200, wobei diese Schicht 101 im Wesentlichen aus Silizium und Germanium bestehen kann. Das Verfahren beinhaltet ferner einen Schritt des Aufbringens von mindestens einer zweiten Schicht 102 auf die erste Schicht 101, wobei die zweite Schicht 102 im Wesentlichen Silizium aufweisen kann. Das Verfahren beinhaltet außerdem einen Schritt des Herstellens einer ersten vertikalen Ausnehmung 111 im Schichtstapel 100, der mindestens die ersten und zweiten Schichten 101, 102 aufweist, wobei die erste vertikale Ausnehmung 111 mittels Trockenätzen hergestellt werden kann und bis auf eine Oberfläche des Substrats 200 reichen kann. Das Verfahren beinhaltet ferner einen Schritt des Aufbaus von mindestens einem Stützelement 105 in der ersten vertikalen Ausnehmung 111, wobei sich das Stützelement 105 vertikal von einer Oberfläche einer der ersten und zweiten Schichten 101, 102 bis zu einer Oberfläche des Substrats 200 erstrecken kann. Das Verfahren beinhaltet außerdem das Herstellen einer zweiten vertikalen Ausnehmung 112 im Schichtstapel 100, der mindestens die ersten und zweiten Schichten 101, 102, aufweist. Die zweite vertikale Ausnehmung 112 kann mittels Trockenätzen hergestellt werden und bis auf eine Oberfläche des Substrats 200 reichen. Ein weiterer Schritt beinhaltet das Entfernen der ersten Schicht 101 (z.B. aufweisend Silizium und/oder Germanium). Erfindungsgemäß wird hierbei ein Trockenätzprozess eingesetzt. Das Verfahren beinhaltet ferner ein Auffüllen des Schichtstapels 100 mit einem Isolatormaterial 103, wie z.B. SiO₂. Ein weiterer Schritt des Verfahrens beinhaltet das Herstellen einer dritten vertikalen Ausnehmung 113 in dem Isolatormaterial 103, wobei diese dritte vertikale Ausnehmung 113 bis auf eine Oberfläche des Substrats 200 reichen kann, sodass die zweite Schicht 102 (z.B. Silizium) lateral freigelegt wird. Das Verfahren beinhaltet ferner das Entfernen der zweiten Schicht 102 (z.B. Si).

Die Erfindung betrifft ferner einen mittels dieses Verfahrens herstellbaren Schichtstapel 100 in einem Halbleiter-Speicher 1000. Der Halbleiter-Speicher 1000 kann beispielsweise ein 3D NAND Flash Speicher Chip bzw. eine 3D NAND Speicherzelle sein.

Die Erfindung betrifft ferner ein Verfahren zum Herstellen eines dreidimensional-integrierten Halbleiterspeichers 1000, wobei das Verfahren einen Schritt des Bereitstellens eines Substrats 200 aufweist, sowie ein Erzeugen eines Schichtstapels 100 mit mehreren Einzelschichten 101, 102 auf dem Substrat 200, indem abwechselnd mehrere Einzelschichten 101 eines ersten Materialtyps sowie mehrere Einzelschichten 102 eines unterschiedlichen zweiten Materialtyps aufgetragen werden. Das Verfahren beinhaltet außerdem einen Schritt des Strukturierens von mindestens einer ersten vertikalen Ausnehmung 111 in dem Schichtstapel 100 und Erzeugen einer Stützstruktur 105 innerhalb der ersten vertikalen Ausnehmung 111, wobei die Stützstruktur 105 mit den jeweiligen Einzelschichten 101, 102 verbunden ist und diese mechanisch stabilisiert. Das Verfahren beinhaltet ferner ein Strukturieren von mindestens einer zweiten vertikalen Ausnehmung 112 in dem Schichtstapel 100, wobei die zweite vertikale Ausnehmung 112 einen Zugang zu den jeweiligen Einzelschichten 101, 102 des Schichtstapels 100 schafft. Darüber hinaus beinhaltet das Verfahren ein selektives Entfernen der zugänglich gemachten Einzelschichten 101 des ersten Materialtyps unter Anwendung eines in lateraler Richtung gerichteten Ätzprozesses mittels eines Ätzgases, das durch die zweite vertikale Ausnehmung 112 hindurch in den Schichtstapel 100 gelangt und die darin zugänglich gemachten Einzelschichten 101 des ersten Materialtyps erreicht und diese in lateraler Richtung selektiv zu den Einzelschichten 102 des zweiten Materialtyps entfernt, sodass nach dem selektiven Entfernen der Einzelschichten 101 des ersten Materialtyps die Einzelschichten 102 des zweiten Materialtyps in dem Schichtstapel 100 verbleiben und sich zwischen den verbleibenden Einzelschichten 102 des zweiten Materialtyps Leerräume 107 bilden. Erfindungsgemäß kennzeichnet sich das Verfahren dadurch, dass die Einzelschichten 101 des ersten Materialtyps Siliziumgermanium aufweisen oder aus Siliziumgermanium bestehen, und der in lateraler Richtung gerichtete Ätzprozess zum selektiven Entfernen der Einzelschichten 101 des ersten Materialtyps in Form eines Trockenätzprozesses unter Verwendung eines Ätzgases ausgeführt wird.

Das hierin beschriebene erfindungsgemäße Verfahren gemäß der ersten Ausführungsform (Figuren 2A bis 2K) kann einen Schritt des Strukturierens einer dritten vertikalen Ausnehmung 113 in dem Schichtstapel 100 aufweisen. Erfindungsgemäß kann dieser Schritt beinhalten, dass die mit dem dritten Material gefüllte zweite vertikale Ausnehmung 112 wieder freigelegt wird, um an derselben Stelle die dritte vertikale Ausnehmung 113 zu erzeugen, oder dass die mit dem dritten Material gefüllte zweite vertikale Ausnehmung 112 verschlossen bleibt und an einer anderen Stelle im Schichtstapel 100 die dritte vertikale Ausnehmung 113 erzeugt wird.

Gemäß dem hierin beschriebenen erfindungsgemäßen Verfahren kann der Schritt des Erzeugens der ersten und/oder zweiten und/oder dritten und/oder vierten vertikalen Ausnehmung 111, 112, 113, 114 beinhalten, dass die jeweilige vertikale Ausnehmung 111, 112, 113, 114 derart erzeugt wird, dass sich diese vollständig durch den Schichtstapel 100 hindurch bis hinunter zu dem Substrat 200 erstreckt.

Gemäß dem hierin beschriebenen erfindungsgemäßen Verfahren kann die erste vertikale Ausnehmung 111 zumindest teilweise mit einem Material gefüllt werden, das sich verfestigt und eine Stützstruktur 105 innerhalb der ersten vertikalen Ausnehmung 111 bildet, wobei diese Stützstruktur 105 dazu dient, um nach dem selektiven Entfernen der Einzelschichten 101 des ersten Materialtyps die bestehenbleibenden Einzelschichten 102 des zweiten Materialtyps mechanisch zu stützen und voneinander beabstandet zu halten, und um nach dem Erzeugen der Einzelschichten 103 des dritten Materialtyps diese mechanisch zu stützen und voneinander beabstandet zu halten.

Beide Ausführungsformen des hierin beschriebenen erfindungsgemäßen Verfahrens dienen zum Herstellen bzw. Erzeugen eines dreidimensional-integrierten Halbleiterspeichers 1000. Hierbei kann es sich beispielsweise um einen 3D NAND-Speicher handeln.

Gemäß dem hierin beschriebenen erfindungsgemäßen Verfahren können die Einzelschichten 104 des vierten Materialtyps jeweils eine Word Line des erzeugten dreidimensional-integrierten Halbleiterspeichers 1000 bilden.

Die oben beschriebenen Ausführungsbeispiele stellen lediglich eine Veranschaulichung der Prinzipien des hierin beschriebenen innovativen Konzepts dar. Es versteht sich, dass Modifikationen und Variationen der hierin beschriebenen Anordnungen und Einzelheiten anderen Fachleuten einleuchten werden. Deshalb ist beabsichtigt, dass das hierin beschriebene Konzept lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

## Patentansprüche

1. Verfahren zum Herstellen eines dreidimensional-integrierten Halbleiterspeichers (1000), wobei das Verfahren die folgenden Schritte aufweist:
Bereitstellen eines Substrats (200),
Erzeugen eines Schichtstapels (100) mit mehreren Einzelschichten (101, 102) auf dem Substrat (200), indem abwechselnd mehrere Einzelschichten (101) eines ersten Materialtyps sowie mehrere Einzelschichten (102) eines unterschiedlichen zweiten Materialtyps aufgetragen werden,
Strukturieren von mindestens einer ersten vertikalen Ausnehmung (111) in dem Schichtstapel (100) und Erzeugen einer Stützstruktur (105) innerhalb der ersten vertikalen Ausnehmung (111), wobei die Stützstruktur (105) mit den jeweiligen Einzelschichten (101, 102) verbunden ist und diese mechanisch stabilisiert,
Strukturieren von mindestens einer zweiten vertikalen Ausnehmung (112) in dem Schichtstapel (100), wobei die zweite vertikale Ausnehmung (112) einen Zugang zu den jeweiligen Einzelschichten (101, 102) des Schichtstapels (100) schafft,
selektives Entfernen der zugänglich gemachten Einzelschichten (101) des ersten Materialtyps unter Anwendung eines in lateraler Richtung gerichteten Ätzprozesses mittels eines Ätzgases, das durch die zweite vertikale Ausnehmung (112) hindurch in den Schichtstapel (100) gelangt und die darin zugänglich gemachten Einzelschichten (101) des ersten Materialtyps erreicht und diese in lateraler Richtung selektiv zu den Einzelschichten (102) des zweiten Materialtyps entfernt, sodass nach dem selektiven Entfernen der Einzelschichten (101) des ersten Materialtyps die Einzelschichten (102) des zweiten Materialtyps in dem Schichtstapel (100) verbleiben und sich zwischen den verbleibenden Einzelschichten (102) des zweiten Materialtyps Leerräume (107) bilden,
Erzeugen von Einzelschichten (103) eines dritten Materialtyps an den Stellen im Schichtstapel (100), an denen sich zuvor die Einzelschichten (102) des zweiten Materialtyps befanden, unter Beibehaltung der Leerräume (107), die sich somit zwischen den Einzelschichten (103) des erzeugten dritten Materialtyps befinden,
**dadurch gekennzeichnet, dass**
die Einzelschichten (101) des ersten Materialtyps Siliziumgermanium aufweisen oder aus Siliziumgermanium bestehen, und
der in lateraler Richtung gerichtete Ätzprozess zum selektiven Entfernen der Einzelschichten (101) des ersten Materialtyps in Form eines Trockenätzprozesses unter Verwendung eines Ätzgases ausgeführt wird.

2. Verfahren nach Anspruch 1,
wobei der Schritt des Erzeugens der Einzelschichten (103) des dritten Materialtyps beinhaltet:
Durchführen einer zumindest teilweisen Oxidation der Einzelschichten (102) des zweiten Materialtyps, sodass die Einzelschichten (102) des zweiten Materialtyps in die Einzelschichten (103) des dritten Materialtyps umgewandelt werden und sich dementsprechend die Einzelschichten (103) des dritten Materialtyps nun an den Stellen im Schichtstapel (100) befinden, an denen sich zuvor die Einzelschichten (102) des zweiten Materialtyps befanden.

3. Verfahren nach Anspruch 1 oder 2,
wobei die Einzelschichten (102) des zweiten Materialtyps Silizium aufweisen und wobei die erzeugten Einzelschichten (103) des dritten Materialtyps Silizium(di)oxid aufweisen,
wobei das Silizium(di)oxid verfahrensgemäß mittels einer thermischen Oxidation des Siliziums erzeugt wird.

4. Verfahren nach Anspruch 1,
wobei der Schritt des Erzeugens der Einzelschichten (103) des dritten Materialtyps beinhaltet:
Belegen der Einzelschichten (102) des zweiten Materialtyps mit einem Beschichtungsmaterial eines zu dem zweiten Materialtyp unterschiedlichen dritten Materialtyps, sodass die mit diesem Beschichtungsmaterial belegten Einzelschichten (102) nun die Einzelschichten (103) des dritten Materialtyps bilden.

5. Verfahren nach Anspruch 4,
wobei das Beschichtungsmaterial elektrisch isolierende Eigenschaften aufweist.

6. Verfahren zum Herstellen eines dreidimensional-integrierten Halbleiterspeichers (1000), wobei das Verfahren die folgenden Schritte aufweist:
Bereitstellen eines Substrats (200),
Erzeugen eines Schichtstapels (100) mit mehreren Einzelschichten (101, 102) auf dem Substrat (200), indem abwechselnd mehrere Einzelschichten (101) eines ersten Materialtyps sowie mehrere Einzelschichten (102) eines unterschiedlichen zweiten Materialtyps aufgetragen werden,
Strukturieren von mindestens einer ersten vertikalen Ausnehmung (111) in dem Schichtstapel (100) und Erzeugen einer Stützstruktur (105) innerhalb der ersten vertikalen Ausnehmung (111), wobei die Stützstruktur (105) mit den jeweiligen Einzelschichten (101, 102) verbunden ist und diese mechanisch stabilisiert,
Strukturieren von mindestens einer zweiten vertikalen Ausnehmung (112) in dem Schichtstapel (100), wobei die zweite vertikale Ausnehmung (112) einen Zugang zu den jeweiligen Einzelschichten (101, 102) des Schichtstapels (100) schafft,
selektives Entfernen der zugänglich gemachten Einzelschichten (101) des ersten Materialtyps unter Anwendung eines in lateraler Richtung gerichteten Ätzprozesses mittels eines Ätzgases, das durch die zweite vertikale Ausnehmung (112) hindurch in den Schichtstapel (100) gelangt und die darin zugänglich gemachten Einzelschichten (101) des ersten Materialtyps erreicht und diese in lateraler Richtung selektiv zu den Einzelschichten (102) des zweiten Materialtyps entfernt, sodass nach dem selektiven Entfernen der Einzelschichten (101) des ersten Materialtyps die Einzelschichten (102) des zweiten Materialtyps in dem Schichtstapel (100) verbleiben und sich zwischen den verbleibenden Einzelschichten (102) des zweiten Materialtyps Leerräume (107) bilden,
Erzeugen von Einzelschichten (103) eines dritten Materialtyps mittels Einbringen eines dritten Materials in die so entstandenen Leerräume (107), sodass sich innerhalb der Leerräume (107) zwischen den verbleibenden Einzelschichten (102) des zweiten Materialtyps jeweils Einzelschichten (103) eines dritten Materialtyps bilden,
Strukturieren von mindestens einer dritten vertikalen Ausnehmung (113) in dem Schichtstapel (100), wobei die dritte vertikale Ausnehmung (113) einen Zugang zu den jeweiligen Einzelschichten (102, 103) des Schichtstapels (100) schafft,
selektives Entfernen der zugänglich gemachten Einzelschichten (102) des zweiten Materialtyps unter Anwendung eines in lateraler Richtung gerichteten Ätzprozesses mittels eines Ätzmediums, das durch die dritte vertikale Ausnehmung (113) hindurch in den Schichtstapel (100) gelangt und die darin zugänglich gemachten Einzelschichten (102) des zweiten Materialtyps erreicht und diese in lateraler Richtung selektiv entfernt, sodass nach dem selektiven Entfernen die Einzelschichten (103) des dritten Materialtyps verbleiben und sich zwischen diesen verbleibenden Einzelschichten (103) des dritten Materialtyps Leerräume (108) bilden,
**dadurch gekennzeichnet, dass**
die Einzelschichten (101) des ersten Materialtyps Siliziumgermanium aufweisen oder aus Siliziumgermanium bestehen, und
der in lateraler Richtung gerichtete Ätzprozess zum selektiven Entfernen der Einzelschichten (101) des ersten Materialtyps in Form eines Trockenätzprozesses unter Verwendung eines Ätzgases ausgeführt wird.

7. Verfahren nach Anspruch 6,
wobei das selektive Entfernen der Einzelschichten (102) des zweiten Materialtyps, unter Beibehaltung der Einzelschichten des dritten Materialtyps (103), unter Anwendung eines Trockenätzprozesses ausgeführt wird, der mindestens einen plasmaunterstützten Ätzschritt mit fluorhaltigen Gasen beinhaltet.

8. Verfahren nach Anspruch 6 oder 7,
wobei der Schritt des Einbringens des dritten Materials in die Leerräume (107) zwischen den bestehenbleibenden Einzelschichten (102) des zweiten Materialtyps beinhaltet, dass ein Prozessgas über die zweite vertikale Ausnehmung (112) diese Leerräume (107) erreicht und sich darin ausbreitet und das dritte Material zwischen den bestehenbleibenden Einzelschichten (102) des zweiten Materialtyps aufwächst.

9. Verfahren nach Anspruch 8,
wobei der Schritt des Einbringens des dritten Materials unter Anwendung eines LPCVD Verfahrens ausgeführt wird.

10. Verfahren nach einem der vorhergehenden Ansprüche,
wobei die Einzelschichten (102) des zweiten Materialtyps Silizium aufweisen oder aus Silizium bestehen.

11. Verfahren nach einem der vorhergehenden Ansprüche,
wobei die Einzelschichten (103) des dritten Materialtyps elektrisch isolierende Eigenschaften aufweisen, und/oder
wobei die Einzelschichten (103) des dritten Materialtyps Silizium(di-)oxid aufweisen oder aus Silizium(di-)oxid bestehen.

12. Verfahren nach einem der vorhergehenden Ansprüche,
wobei der Trockenätzprozess zum selektiven Entfernen der Einzelschichten (101) des ersten Materialtyps bei Temperaturen von über 350°C ausgeführt wird und wobei das Ätzgas Chlorwasserstoff enthält oder aus Chlorwasserstoff besteht.

13. Verfahren nach einem der vorhergehenden Ansprüche,
wobei nach dem Schritt des Erzeugens der Einzelschichten (103) des dritten Materialtyps die dazwischen entstandenen Leerräume (107, 108) mit einem vierten Material gefüllt werden, sodass sich zwischen den Einzelschichten (103) des dritten Materialtyps jeweils Einzelschichten (104) eines vierten Materialtyps bilden, wobei der vierte Materialtyp unterschiedlich zu dem dritten Materialtyp ist und elektrisch leitfähig ist.

14. Verfahren nach Anspruch 13,
wobei die Einzelschichten (104) des vierten Materialtyps ein elektrisch leitfähiges Metall, insbesondere mindestens eine Komponente aus der Gruppe von Wolfram, Kobalt, Molybdän oder Ruthenium, aufweisen oder daraus bestehen, oder
wobei die Einzelschichten (104) des vierten Materialtyps einen dotierten Halbleiter, insbesondere dotiertes Silizium, aufweisen oder daraus bestehen.

15. Dreidimensional-integrierter Halbleiterspeicher (1000) herstellbar nach einem Verfahren gemäß einem der vorhergehenden Ansprüche.
